Europäisches Patentamt

European Patent Office

Office européen des brevets

(11) Veröffentlichungsnummer: **0 383 400 B1**

(12) **EUROPÄISCHE PATENTSCHRIFT**

(45) Veröffentlichungstag der Patentschrift: **20.09.95**

(51) Int. Cl.[6]: **C30B 29/28**, C30B 15/00

(21) Anmeldenummer: **90200329.2**

(22) Anmeldetag: **13.02.90**

(54) **Verfahren zur Züchtung von Mischkristallen aus Schmelzen oxidischer Vielstoffsysteme.**

(30) Priorität: **17.02.89 DE 3904868**

(43) Veröffentlichungstag der Anmeldung:
**22.08.90 Patentblatt 90/34**

(45) Bekanntmachung des Hinweises auf die Patenterteilung:
**20.09.95 Patentblatt 95/38**

(84) Benannte Vertragsstaaten:
**AT CH DE ES FR GB IT LI NL SE**

(56) Entgegenhaltungen:
**EP-A- 0 170 309
EP-A- 0 279 490
FR-A- 2 278 632**

**JOURNAL OF CRYSTAL GROWTH, Band 26, 1974, Seiten 169-170, Amsterdam, NL; C.D. BRANDLE et al.: "Crystal stoichiometry of czochralski grown rare-earth gallium garnets"**

**THE RADIO AND ELECTRONIC ENGINEER, Band 45, Nr. 12, Dezember 1975, Seiten 711-724, London, GB; E.A.D. WHITE et al.: "Bubble materials-composition, growth and evaluation"**

(73) Patentinhaber: **Philips Patentverwaltung GmbH
Wendenstrasse 35c
D-20097 Hamburg (DE)**

(84) Benannte Vertragsstaaten:
**DE**

(73) Patentinhaber: **Philips Electronics N.V.
Groenewoudseweg 1
NL-5621 BA Eindhoven (NL)**

(84) Benannte Vertragsstaaten:
**CH ES FR GB IT LI NL SE AT**

(72) Erfinder: **Mateika, Dieter, Dr.
Seerosenstrasse 16
D-2087 Ellerbek (DE)**
Erfinder: **Völkel, Erich, Dipl.-Ing.
Wiesinger Weg 34
D-2000 Hamburg 20 (DE)**
Erfinder: **Haisma, Jan, Dr., Dipl.-Ing.
72 Kornoeljekaan
NL-5552 RD Valkerswaard (NL)**

(74) Vertreter: **Volmer, Georg, Dipl.-Ing. et al
Philips Patentverwaltung GmbH,
Wendenstrasse 35c
D-20097 Hamburg (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

MATERIALS RESEARCH BULLETIN, Band 7, Nr. 11, November 1972, Seiten 1219-1224, Oxford, GB; S. GELLER et al.: "Thermal expansion of some garnets"

**Beschreibung**

Die Erfindung betrifft ein Verfahren zur Züchtung von Mischkristallen mit mindestens zwei Gitterplätzen mit jeweils einer unterschiedlichen Anzahl benachbarter Sauerstoffionen aus Schmelzen oxidischer Vielstoffsysteme sowie die Anwendung der nach diesem Verfahren hergestellten Mischkristalle.

Um homogene Kristalle zu erhalten, muß die Bedingung erfüllt sein, daß der Verteilungskoeffizient der Kationen $k_{eff(kat)}$, also das Verhältnis der Konzentration der Kationen in der Solidusphase zur Konzentration der Kationen in der Liquidusphase $C_s/C_l$ etwa bei 1 liegt. Für technische Anwendungszwecke brauchbare Kristalle ergeben sich bei kleinen Kationenkonzentrationen ($\leq$ 0,5 Formeleinheiten) auch noch mit Verteilungskoeffizienten im Bereich von 0,90 bis 1,20.

Unter Kristallen ist sowohl monokristallines als auch polykristallines Material zu verstehen.

Granateinkristalle z.B. werden als Substrate für die Herstellung von magnetischen und magnetooptischen Schichten benötigt. Anwendungsbeispiele für solche Materialschichten sind: Magnetblasenspeicher, Displays und optische Isolatoren. Weiterhin können Granateinkristalle auch als Substrate für die epitaktische Herstellung von Halbleiterschichten benutzt werden.

Ein anderes Anwendungsgebiet für Granate sind Laserkristalle und Detektoren. Bei diesen Anwendungsbeispielen werden Granate als Wirtsgitter für fluoreszierende Ionen benutzt. Neben der Herstellung von kompakten Laserkristallen werden Granateinkristalle auch als Substrate für die Herstellung von dünnen Schichten mit Lasereigenschaften benötigt.

Einkristalline Schichten können z.B. durch einen Epitaxieprozeß, z.B. einen Flüssigphasenepitaxieprozeß, auf einkristalline Substrate aufgebracht werden. Ein einkristallines Wachstum der Schicht mit der erforderlichen Perfektion kann jedoch nur dann stattfinden, wenn Substrat und epitaxiale Schicht nahezu die gleiche kristallographische Gitterkonstante haben. Die Gitterkonstante ändert sich mit der Zusammensetzung, so daß für jede Schichtzusammensetzung ein Substrat mit einer angepaßten Gitterkonstante benötigt wird.

Zum Beispiel liegen gewünschte Gitterkonstanten für Granatsubstrate für die oben genannten Anwendungszwecke im Bereich von 1,19 bis 1,30 nm. Dieser Gitterkonstantenbereich kann mit den bisher bekannten Granatzusammensetzungen nicht lückenlos abgedeckt werden.

Als Ausweg bietet sich die Züchtung von Mischkristallen, bei denen die Gitterkonstante über die Kristallzusammensetzung eingestellt wird. Dies gilt nicht nur für Granate sondern allgemein für das Wachstum einkristalliner Schichten auf einkristallinen Substraten. Für technische Anwendungen haben z.B. auch Perowskite und Spinelle eine wachsende Bedeutung.

Anhand von Granatzusammensetzungen soll diese Problematik näher erläutert werden.

Granat kristallisiert mit kubischer Kristallstruktur.

Für die Kationen im Granatgitter gibt es drei unterschiedliche Gitterplätze (Dodekaeder-, Oktaeder-, und Tetraederplatz). Kationen mit den größten Ionenradien besetzen zunächst den Dodekaederplatz bis zu 3 Formeleinheiten und haben als nächste Nachbarn 8 Sauerstoffionen. Kationen mit den nächstfolgenden kleineren Radien besetzen den Oktaederplatz und haben 6 Sauerstoffionen als nächste Nachbarn, während die kleinsten Kationen den Tetraederplatz besetzen und von nur 4 Sauerstoffionen umgeben werden. Die Gitterplätze sind über Kanten und Ecken miteinander verbunden. Die unterschiedlichen Gitterplätze werden durch folgende Klammern gekennzeichnet: Dodekaederplatz { }, Oktaederplatz [ ], Tetraederplatz ( ).

Granate können durch die allgemeine Formel $\{A^{3+}\}_3[B^{3+}]_2(C^{3+})_3O_{12}$ beschrieben werden, wobei A, B und C Kationen mit unterschiedlichen Radien sind. Bei Granaten mit einfacher Zusammensetzung, wie z.B. $\{Gd\}_3[Ga]_2(Ga)_3O_{12}$, sind die Dodekaederplätze mit $Gd^{3+}$-Ionen, die Oktaeder- und Tetraederplätze mit $Ga^{3+}$-Ionen besetzt.

Es ist bekannt, Mischkristalle durch Mischen zweier Granate mit einfacher Zusammensetzung (auch Endglieder genannt) herzustellen. So können z.B. Mischkristalle der Zusammensetzung $\{Gd,Sm\}_3[Ga]_2(Ga)_3O_{12}$ durch Mischen der beiden Endglieder $\{Gd\}_3[Ga]_2(Ga)_3O_{12}$ und $\{Sm\}_3[Ga]_2(Ga)_3O_{12}$ hergestellt werden. Bei diesen Mischkristallen werden die kleineren $Gd^{3+}$-Ionen (r = 0,1061 nm) sukzessive durch die größeren $Sm^{3+}$-Ionen (r = 0,1087 nm) auf den Dodekaederplätzen ausgetauscht. Die Gitterkonstante dieser Mischkristalle vergrößert sich linear mit steigendem Sm-Gehalt von 1,2382 nm bis auf 1,2438 nm.

Der Nachteil der durch Mischen von Endgliedern hergestellten Mischkristalle ist die Änderung der Konzentration der den Dodekaederplatz besetzenden Kationen im Kristall vom Anfang bis hin zum Kristallende; für das oben genannte Beispiel wäre dies die Gd/Sm-Konzentration.

Ein Maß für diese Inhomogenität ist der Verteilungskoeffizient der Kationen $k_{eff(kat)}$. Er ist definiert als das Verhältnis der Konzentration der Kationen im Kristall zu der in der Schmelze ($k_{eff(kat)} = C_s/C_l$). Im obigen Beispiel ist der Verteilungskoeffizient von Gadolinium größer 1. Hierdurch kommt es zu einer Anreicherung von Gadolinium im Kristallanfang und entsprechend der Abnahme der Gd-Konzentration in der Schmelze während des Wachstumsprozesses zu einer Verarmung an Gadolinium im Kristallende.

Wegen der Abhängigkeit der Gitterkonstante a von der Kristallzusammensetzung steigt die Gitterkonstante vom Kristallanfang bis hin zum Ende an.

Homogene Mischkristalle, also Mischkristalle, die über die gesamte Länge des gezogenen Kristalls eine etwa gleiche Gitterkonstante haben, können nur dann erhalten werden, wenn die Verteilungskoeffizienten der Kationen etwa 1 sind. Mischkristalle, die durch Mischen zweier Endglieder hergestellt werden, haben jedoch Verteilungskoeffizienten, die relativ weit von 1 abweichen. Wegen der daraus resultierenden geringen Kristallqualität und der Änderung der Gitterkonstante in Längsrichtung des Kristalls sind Mischkristalle, die durch Mischen zweier Endglieder hergestellt werden, im allgemeinen für technische Anwendungen nicht zu gebrauchen. Ein Ausweg könnte die Anwendung von Vielstoffsystemen sein, die wegen ihrer größeren Anzahl von Kationen mehr Möglichkeiten bieten, die Verteilungskoeffizienten über die Zusammensetzung zu optimieren. Wege hierzu sind jedoch nicht bekannt.

Der Erfindung liegt die Aufgabe zugrunde, ein Verfahren anzugeben, mit dem Zusammensetzungen oxidischer Vielstoffsysteme gefunden werden können, die geeignet sind für die Herstellung von Mischkristallen mit Verteilungskoeffizienten nahe bei 1.

Diese Aufgabe wird erfindungsgemäß dadurch gelöst, daß homogene Mischkristalle mit Granat-, Perowskit- oder Spinellstruktur gezüchtet werden, derart, daß die Kationen für die Besetzung des ersten Gitterplatzes mit der höchsten Anzahl benachbarter Sauerstoffionen und für die Besetzung des zweiten Gitterplatzes mit der nächst niedrigeren Anzahl benachbarter Sauerstoffionen so ausgewählt werden, daß das Verhältnis der mittleren, für den ersten Gitterplatz berechneten Bindungslänge der Kationen auf dem ersten Gitterplatz zur miitleren, für den zweiten Gitterplatz berechneten Bindungslänge der Kationen auf dem zweiten Gitterplatz im Bereich von 0,7 bis 1,5 liegt.

Nach einer vorteilhaften Weiterbildung des erfindungsgemäßen Verfahrens wird zur Züchtung von Mischkristallen auf Basis von Seltenerdmetall-Gallium-Granat die Zusammensetzung der die Schmelze bildenden Komponenten in Abhängigkeit jeweils der Bindungslängen des Dodekaederplatzes {A(1)-O} und des Oktaederplatzes [B-O] so ausgewählt, daß die mittlere, für den Dodekaederplatz berechenten Bindungslänge des Dodekaederplatzes {A(1)-O} im Bereich von 0,2361 nm bis 0,2453 nm und die mittlere, für den Oktaederplatz berechnete Bindungslänge des Oktaederplatzes [B-O] im Bereich von 0,2008nm bis 0,2108 nm liegt.

Nach einer weiteren vorteilhaften Ausgestaltung des erfindungsgemäßen Verfahrens werden Mischkristalle gezüchtet mit einer Zusammensetzung gemäß der allgemeinen Formel

$$\{RE_{3-x}Ca_x\}[Ga_{2-x-y-2z}R_yMg_zHf_{x+z}](Ga_3)O_{12},$$

worin sind

RE = ein Kation aus der Gruppe
$Gd^{3+}$, $Tb^{3+}$, $Dy^{3+}$, $Ho^{3+}$, $Y^{3+}$, $Er^{3+}$,
R = In und/oder RE und

$$0 \leq x \leq 0,55$$
$$0,01 \leq y \leq 0,28$$
$$0 \leq z \leq 0,55$$
$$0,15 \leq x + z \leq 0,60.$$

Nach einer weiteren vorteilhaften Ausgestaltung des Verfahrens gemäß der Erfindung werden Mischkristalle gezüchtet mit einer Zusammensetzung gemäß der allgemeinen Formel

$$\{RE_{3-x}Ca_x\}[Ga_{2-x-y-2z}RE_yMg_zZr_{x+z}](Ga_3)O_{12},$$

worin sind

RE = ein Kation aus der Gruppe $Sm^{3+}$, $Eu^{3+}$, $Tb^{3+}$ und

$$0 \leq x \leq 0,58$$
$$0 \leq y \leq 0,10$$
$$0 \leq z \leq 0,50$$
$$0,15 \leq x + z \leq 0,68.$$

Nach weiteren vorteilhaften Ausgestaltungen des Verfahrens nach der Erfindung werden für die Anfangsglieder der Mischkristallreihen der Systeme gemäß der allgemeinen Formel

$$\{RE_{3-x}Ca_x\}\{Ga_{2-x-y-2z}R_yMg_zHf_{x+z}](Ga_3)O_{12}$$

die Bindungslänge des Dodekaederplatzes berechnet mit

$$\{A(1)\text{-}O\} = 0{,}30362 - 1{,}4571 \cdot \{r_{RE}\} + 7{,}8443 \cdot \{r_{RE}\}^2$$

(in Nanometer) und die Bindungslänge des Oktaederplatzes mit
$[B\text{-}O] = 0{,}25836 - 0{,}5436 \cdot \{r_{RE}\}$ (in Nanometer), worin $\{r_{RE}\}$ der Radius des Seltenerdmetallions auf dem Dodekaederplatz ist. Die Zunahme der Bindungslängen jeweils des Dodekaederplatzes $\Delta \{A(1)\text{-}O\}$ und des Oktaederplatzes $\Delta [B\text{-}O]$ der Systeme der Mischkristallreihen wird berechnet (in Nanometer) mit

$$\Delta\{A(1)\text{-}O\} = 0{,}1024 \cdot [\Delta r] + 19{,}8482 \cdot [\Delta r]^2 \text{ und}$$
$$\Delta[B\text{-}O] = 0{,}6802 \cdot [\Delta r].$$

Nach weiteren vorteilhaften Ausgestaltungen des Verfahrens nach der Erfindung werden für die Anfangsglieder der Mischkristallreihen der Systeme gemäß der allgemeinen Formel

$$\{RE_{3-x}Ca_x\} [Ga_{2-x-y-2z}RE_yMg_zZr_{x+z}] (Ga_3) O_{12}$$

die Bindungslänge des Dodekaederplatzes berechnet mit

$$\{A(1)\text{-}O\} = 0{,}25119 - 0{,}4027 \cdot \{r_{RE}\} + 2{,}6730 \cdot \{r_{RE}\}^2 \text{ (in Nanometer)}$$

und die Bindungslänge des Oktaederplatzes mit $[B\text{-}O] = 0{,}26266 - 0{,}5645 \cdot \{r_{RE}\}$ (in Nanometer), worin $\{r_{RE}\}$ der Radius des Seltenerdmetallions auf dem Dodekaederplatz ist. Die Zunahme der Bindungslängen jeweils des Dodekaederplatzes $\Delta \{A(1)\text{-}O\}$ und des Oktaederplatzes $\Delta [B\text{-}O]$ der Systeme der Mischkristallreihen wird berechnet mit

$$\Delta \{A(1)\text{-}O\} = 0{,}2070 \cdot [\Delta r] + 6{,}0593 \cdot [\Delta r]^2 \text{ (in Nanometer) und}$$
$$\Delta [B\text{-}O] = 0{,}6961 \cdot [\Delta r] \text{ (in Nanometer).}$$

Mit den oben angegebenen Formeln zur Berechnung der Bindungslängen jeweils des Dodekaederplatzes $\{A(1)\text{-}O\}$ und des Oktaederplatzes $[B\text{-}O]$ und deren Zunahmen $\Delta \{A(1)\text{-}O\}$ und $\Delta [B\text{-}O]$ ist es möglich, selektiv alle die Zusammensetzungen innerhalb der oben genannten Systeme zu ermitteln, die den Verteilungskoeffizienten $k_{eff(kat)}$ nahe bei 1 aufweisen.

Der Fachmann kann entsprechende Formeln für gewünschte Mischkristallreihen anderer Zusammensetzungen empirisch ermitteln unter Zugrundelegen der Radien der den ersten und den zweiten Gitterplatz besetzenden Kationen in Abhängigkeit von deren Abstand zum benachbarten Sauerstoff. Diese Daten sind aus der Struktur der gewünschten Zusammensetzungen zu erhalten.

Nach einer weiteren vorteilhaften Ausgestaltung des Verfahrens gemäß der Erfindung werden Mischkristalle gezüchtet mit einer Zusammensetzung gemäß der allgemeinen Formel $RE_{1-x}Sr_xGa_{1-y}Zr_yO_3$, worin sind

RE =   ein Kation aus der Gruppe $La^{3+}, Pr^{3+}, Nd^{3+}$ und

$$0{,}05 \leq x \leq 0{,}10$$
$$0{,}05 \leq y \leq 0{,}10.$$

Vorzugsweise wird ein Mischkristall gezüchtet mit einer Schmelzzusammensetzung gemäß der Formel

$$La_{0{,}95}Sr_{0{,}05}Ga_{0{,}95}Zr_{0{,}05}O_3.$$

Dieser Mischkristall hat orthorhombische Perowskitstruktur, wobei der erste, von $La^{3+}$ und $Sr^{2+}$ besetzte Gitterplatz von 8 benachbarten Sauerstoffionen und der zweite, von $Ga^{3+}$ und $Zr^{4+}$ besetzte Gitterplatz von 6 benachbarten Sauerstoffionen umgeben ist.

Die Kristallzusammensetzung dieses Mischkristalls entspricht der Formel $La_{0{,}95}Sr_{0{,}05}Ga_{0{,}96}Zr_{0{,}04}O_3$,

wobei die Verteilungskoeffizienten

für La$^{3+}$ = 1,00, für Sr$^{2+}$ = 1,00, für Ga$^{3+}$ = 1,01

und für Zr$^{4+}$ = 0,80 betragen.

Mit dem Verfahren gemäß der Erfindung ist der Vorteil verbunden, daß Mischkristallreihen mit jeweils einem Anfangs- und einem Endglied erstellt werden können, innerhalb derer alle Mischkristalle einen Verteilungskoeffizienten nahe bei 1 haben.

Die nach dem erfindungsgemäßen Verfahren hergestellten Mischkristalle können mit Vorteil verwendet werden als Substrat für die Herstellung monokristalliner Schichten auf Substraten, wobei die Gitterkonstante der abzuscheidenden Schicht über ihre Zusammensetzung innerhalb relativ weiter Grenzen an die Gitterkonstante des Substrates angepaßt werden kann. Monokristalline Schichten sind z.B. epitaxiale Schichten, die nach bekannten Verfahren, wie z.B. Flüssigphasenepitaxie oder Gasphasenepitaxie oder durch einen Kathodenzerstäubungsprozeß mit anschließender Temperung, hergestellt werden. Monomolekulare epitaxiale Schichten können durch "atomic layer epitaxy" hergestellt werden.

Die nach dem erfindungsgemäßen Verfahren hergestellten Mischkristalle können auch mit Vorteil als Substrat für die Herstellung von auf einem Substrat angebrachten Vielschichtstrukturen aus unterschiedlichen monokristallinen Schichten einer Dicke von jeweils > 100 x a oder < 100 x a verwendet werden, wobei a die Gitterkonstante des Materials der jeweiligen Schicht ist.

Mit Vielschichtstrukturen aus unterschiedlichen monokristallinen Schichten einer Dicke von jeweils > 100 x a können z.B. Superstrukturen aufgebaut werden; Superstrukturen sind Vielschichtstrukturen mit Einzelschichten unterschiedlicher Eigenschaften.

Mit Vielschichtstrukturen aus unterschiedlichen monokristallinen Schichten einer Dicke von jeweils < 100 x a können z.B. Supergitter aufgebaut werden. Supergitter sind Vielschichtstrukturen mit Einzelschichten sehr geringer Schichtdicke (jedoch größer als monomolekular), in denen die intrinsischen Eigenschaften des "bulk"-Materials entsprechender Zusammensetzung, also eines Einkristalls mit größeren Abmessungen (> 100 x a), noch nicht ausgebildet sind.

Der Erfindung liegt folgende Erkenntnis zugrunde:

Wenn die Bindungskräfte für die zu substituierenden Kationen (Kationen des Wirtsgitters) etwa den Bindungskräften der in das Wirtsgitter einzubauenden Kationen (Substituenten) entsprechen, muß der Verteilungskoeffizient $k_{eff(kat)} = C_s/C_l$ nahe bei 1 liegen. Diese Hypothese hat sich bestätigt.

Ein Maß für die Bindungskräfte der Kationen im Kristallgitter ist ihr Abstand zu den benachbarten Sauerstoffionen. Dieser Abstand wird Bindungslänge genannt. Die mittleren Bindungslängen für Granate können nach Hawthorne (J. Solid State Chemistry, 37 (1981), Seiten 157 bis 164) und Basso (Neues Jahrbuch der Mineralogie, Monatsheft 3, (1985), Seiten 108-114) berechnet werden. Zunächst werden die Gitterparameter x, y, z der Sauerstoffionen nach den Gleichungen (1) bis (3) ermittelt:

$$x = 0,0278 \{r\} + 0,0123 [r] - 0,0482 (r) + 0,0141 \qquad (1)$$
$$y = - 0,0237 \{r\} + 0,0200 [r] + 0,0321 (r) + 0,0523 \qquad (2)$$
$$z = - 0,0102 \{r\} + 0,0305 [r] - 0,0217 (r) + 0,6519. \qquad (3)$$

r sind die mittleren Radien aller Kationen auf den unterschiedlichen Gitterplätzen.

Die mittleren Bindungslängen ergeben sich aus den nachfolgenden Gleichungen (4) bis (7):

$$\{A(1)\text{-}O\}^2 = a_o^2[(x+1/8)^2 + y^2 + (z\text{-}3/4)^2] \qquad (4)$$
$$\{A(2)\text{-}O\}^2 = a_o^2[x^2 + (y\text{-}1/4)^2 + (z\text{-}5/8)^2] \qquad (5)$$
$$[B\text{-}O]^2 = a_o^2[x^2 + y^2 + (z\text{-}1/2)^2] \qquad (6)$$
$$(C\text{-}O)^2 = a_o^2[(x\text{-}1/8)^2 + y^2 + (z\text{-}3/4)^2]. \qquad (7)$$

Zu den Gleichungen (4) und (5) ist anzumerken, daß für den Dodekaederplatz wegen seiner Deformation (verzerrter Würfel) zwei mittlere Bindungslängen {A(1)-O} und {A(2)-O} erhalten werden. Für die dem Verfahren der vorliegenden Erfindung zugrundeliegenden Berechnungen wurde nur die Bindungslänge gemäß {A(1)-O} berücksichtigt.

Mit den genannten Gleichungen (1) bis (7) nach Hawthorne und Basso ist es nicht möglich, selektiv nur die Zusammensetzungen zu ermitteln, die Verteilungskoeffizienten $k_{eff(kat)}$ von 1 oder nahe bei 1 haben. Mit diesen bekannten Gleichungen ergeben sich Zusammensetzungen mit allen möglichen Verteilungskoeffizienten von $k_{eff(kat)} \ll 1$ bis $k_{eff(kat)} \gg 1$.

Um im Rahmen des vorliegenden Verfahrens Granatmischkristalle mit Verteilungskoeffizienten nahe bei 1 aus Schmelzen oxidischer Vielstoffsysteme herzustellen, wurde das Verfahren der gekoppelten Substitution benutzt.

Im Granatgitter gibt es drei Möglichkeiten für eine gekoppelte Substitution.

1. Gekoppelte Substitution auf einem Gitterplatz (Oktaederplatz), z.B.:

$$[2B^{3+}] \rightarrow [D^{2+}] + [E^{4+}]$$

Für D können z.B. die Kationen $Ni^{2+}$, $Mg^{2+}$, $Cu^{2+}$, $Co^{2+}$, $Mn^{2+}$ und für E die Kationen $Sn^{4+}$, $Hf^{4+}$, $Zr^{4+}$ eingesetzt werden. Solche Mischkristalle können durch die allgemeine Formel

$$\{A_3^{3+}\}[B_{2-2x}^{3+}D_x^{2+}E_x^{4+}](C_3^{3+})O_{12}$$

beschrieben werden. Wegen des Ladungsausgleichs ist $D_x = E_x$.

2. Gekoppelte Substitution auf unterschiedlichen Gitterplätzen (Dodekaederplatz und Oktaederplatz), z.B.:

$$\{A^{3+}\} + [B^{3+}] \rightarrow \{F^{2+}\} + [E^{4+}]$$

mit den allgemeinen Formeln für die Mischkristalle:

$$(2.1) \qquad \{A_{3-y}^{3+} F_y^{2+}\}[B_{2-x}^{3+} E_x^{4+}](C_3^{3+})O_{12}$$

$$(2.2) \qquad \{A_{3-y}^{3+} F_y^{2+}\}[B_{2-y-2x}^{3+} D_x^{2+} E_{x+y}^{4+}](C_3^{3+})O_{12}.$$

In der allgemeinen Formel (2.1) ist auf dem Dodekaeder- und dem Oktaederplatz jeweils nur ein Kation als Substituent eingesetzt, während in der Formel gemäß (2.2) ein weiteres, zweiwertiges Gastion auf dem Oktaederplatz eingesetzt wird. Für F können z.B. die Kationen $Mg^{2+}$, $Ca^{2+}$, $Sr^{2+}$, $Mn^{2+}$ und $Th^{4+}$ ausgewählt werden.

3. Gekoppelte Substitution auf drei unterschiedlichen Gitterplätzen (Dodekaederplatz, Oktaederplatz, Tetraederplatz), z.B.:

$$\{A^{3+}\} + [B^{3+}] + (2C^{3+}) \rightarrow \{F^{2+}\} + [D^{2+}] + (2G^{4+})$$

mit der allgemeinen Formel für die Mischkristalle:

$$\{A_{3-x}^{3+} F_x^{2+}\}[B_{2-y}^{3+} D_y^{2+}](C_{3-x-y}^{3+} G_{x+y}^{4+})O_{12}$$

Auch bei diesem Beispiel ist es möglich, mehrere Kationen als Substituenten auf unterschiedlichen Gitterplätzen einzusetzen. Als Kation für G bieten sich z.B. an $Ge^{4+}$, $Sn^{4+}$ oder $Ti^{4+}$.

Ein wesentlicher Vorteil der gekoppelten Substitution mit Kationen unterschiedlicher Wertigkeit liegt darin, daß der Ladungsausgleich als zusätzliche Bindungskraft für die Gastionen (Substituenten) hinzukommt.

Für Perowskite kann die Bindungslänge aus den Gitterkonstanten a berechnet werden. Für die Kationen A für die Besetzung des ersten Gitterplatzes mit der höchsten Anzahl benachbarter Sauerstoffionen O kann die mittlere Bindungslänge A bis O berechnet werden aus

$$(A\text{-}O) = \frac{a}{2} \sqrt{2} \ ;$$

Besetzung des zweiten Gitterplatzes mit der nächst niedrigeren Anzahl benachbarter Sauerstoffionen O kann die mittlere Bindungslänge B bis O berechnet werden aus

$$(B\text{-}O) = \tfrac{a}{2} \; .$$

Für Spinelle kann die Bindungslänge ebenfalls aus den Gitterkonstanten a berechnet werden (hierzu wird z.B. auch verwiesen auf die Arbeit von R.P. van Stapele in Ferromagnetic Materials Vol. 3, North-Holland Publishing Company 1982, Seiten 607 bis 611). Für die Kationen A für die Besetzung des ersten Gitterplatzes mit der höchsten Anzahl benachbarter Sauerstoffionen O kann die mittlere Bindungslänge A bis O berechnet werden aus

$$(A\text{-}O) = a\sqrt{3}\,(\delta + \tfrac{1}{8}\,);$$

für die Kationen B für die Besetzung des zweiten Gitterplatzes mit der nächst niedrigeren Anzahl benachbarter Sauerstoffionen O kann die mittlere Bindungslänge B bis O berechnet werden aus

$$(B\text{-}O) = a\,(\tfrac{1}{16} - \tfrac{1}{2}\,\delta + 3\,\delta^2)\tfrac{1}{2}\; ;$$

$\delta = u - \tfrac{3}{8}$ ; u = Parameter des Sauerstoffions in der kristallographischen [111]-Richtung. Bei unverzerrtem Sauerstoff-Tetraeder ist u = $\tfrac{3}{8}$ .

Im folgenden werden Ausführungsbeispiele der Erfindung beschrieben und ihre Wirkungsweise erläutert.

Die Figuren zeigen:

Figur 1    das Verhältnis der Bindungslänge des Dodekaederplatzes {A(1)-O} zur Bindungslänge des Oktaederplatzes [B-O] für Mischkristalle der Zusammensetzung gemäß der allgemeinen Formel

$[RE_{3-x}Ca_x][Ga_{2-x-y-2z}R_yMg_zHf_{x+z}](Ga_3)O_{12}$ mit

$$0 \le x \le 0,55$$
$$0,01 \le y \le 0,28$$
$$0 \le z \le 0,55$$
$$0,15 \le x + z \le 0,60,$$

mit RE = $Gd^{3+}$, $Tb^{3+}$, $Dy^{3+}$, $Y^{3+}$, $Er^{3+}$ und
R = In und/oder RE.

Figur 2    die Änderung der Bindungslänge des Oktaederplatzes $\Delta$ [B - O] mit der Änderung der mittleren Radien der Kationen auf dem Oktaederplatz [$\Delta \bar{r}$] für die Mischkristallzusammensetzungen gemäß Figur 1.

Figur 3    das Verhältnis der Bindungslänge des Dodekaederplatzes {A(1)-O} zur Bindungslänge des Oktaederplatzes [B-O] für Mischkristalle der allgemeinen Zusammensetzung

$\{RE_{3-x}Ca_x\}[Ga_{2-x-y-2z}RE_yMg_zZr_{x+z}](Ga_3)O_{12}$ mit

$$0 \le x \le 0,58$$
$$0 \le y \le 0,10$$
$$0 \le z \le 0,50$$
$$0,15 \le x + z \le 0,68 \text{ und mit}$$

RE = $Sm^{3+}$, $Eu^{3+}$, $Gd^{3+}$, $Tb^{3+}$.

Figur 4    die Änderung der Bindungslänge des Oktaederplatzes $\Delta$ [B-O] mit der Änderung der mittleren Radien der Kationen auf dem Oktaederplatz [$\Delta \bar{r}$] für die Mischkristallzusammensetzungen gemäß Figur 3

Figur 5    die Abhängigkeit der Bindungslänge des Dodekaederplatzes {A(1)-O} vom Radius der Seltenerdmetallionen auf dem Dodekaederplatz {$r_{RE}$} für die Mischkristallzusammensetzungen gemäß Figur 1 und Figur 3.

Figur 6    die Abhängigkeit der Bindungslänge des Oktaederplatzes [B-O] vom Radius der Seltenerdmetallionen auf dem Dodekaederplatz {$r_{RE}$} für die Mischkristallzusammensetzungen gemäß Figur 1 und Figur 3.

Figur 7    die Änderung der Bindungslänge des Dodekaederplatzes $\Delta$ {A(1)-O} mit der Änderung der mittleren Radien der Kationen auf dem Oktaederplatz [$\Delta \bar{r}$] für die Mischkristallzusammenset-

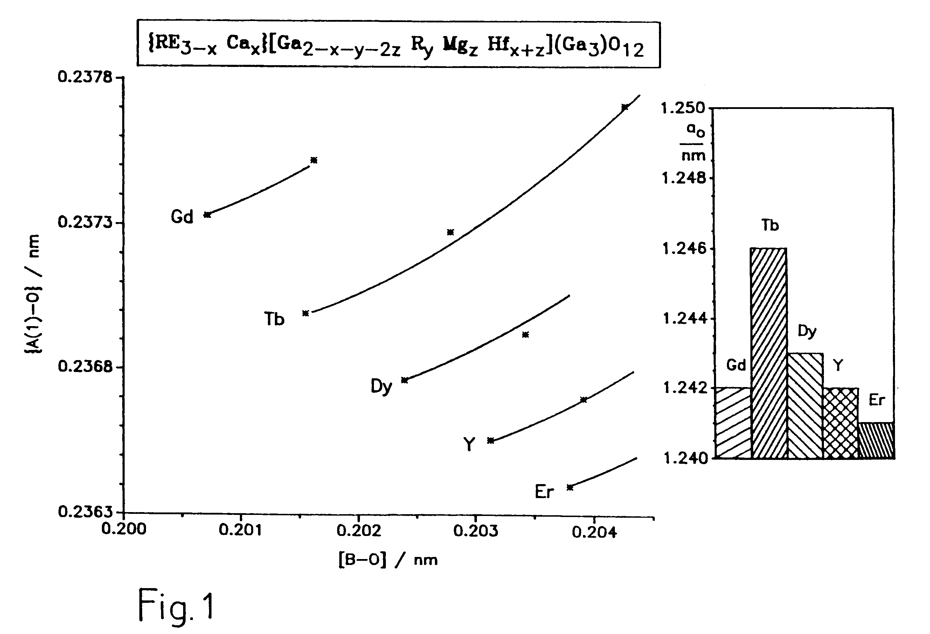

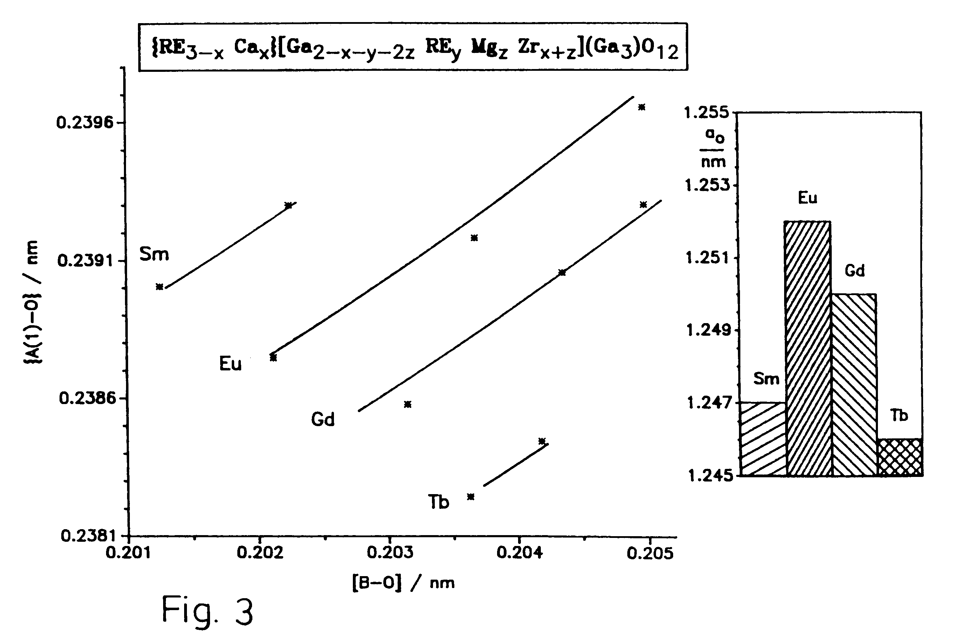

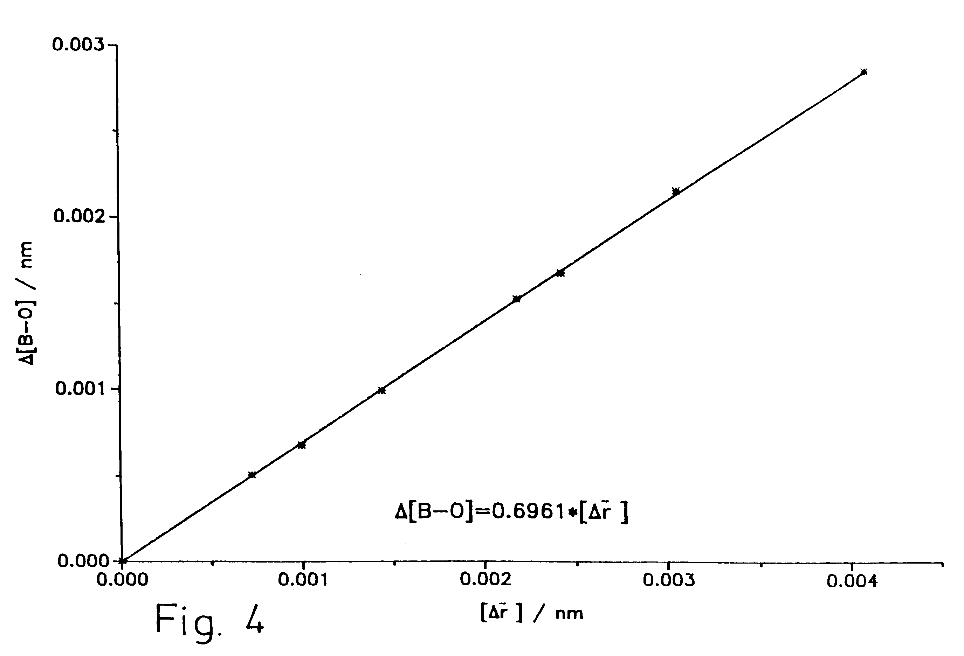

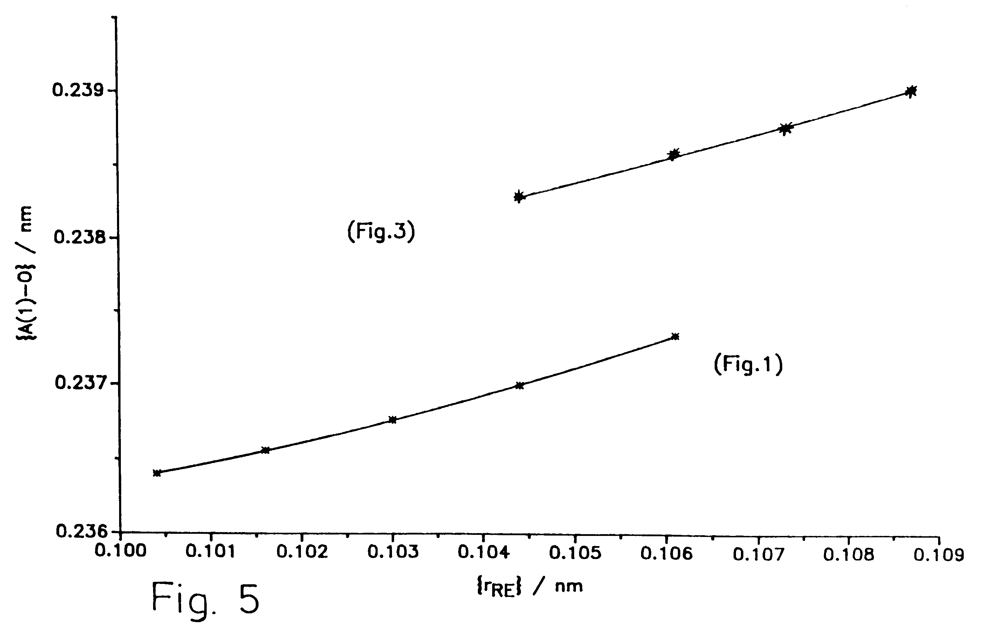

zungen gemäß Figur 1 und Figur 3.

Zur Herstellung der Mischkristalle werden Seltenerdmetall-Gallium-Granate als Wirtsgitter für die Substituenten benutzt. Als Substituenten kommen aufgrund ihrer Radien z.B. die Kationen $Gd^{3+}$, $Tb^{3+}$, $Dy^{3+}$, $Y^{3+}$, $Er^{3+}$ in Betracht; mit Vorteil können jedoch auch zwei- und vierwertige Kationen mit geeigneten Radien für die gekoppelte Substitution ausgewählt werden.

Zur Herstellung von Schmelzproben werden die Oxide der ausgewählten Granatzusammensetzungen gemischt und in einem Iridiumtiegel unter schwach oxidierender Atmosphäre aufgeschmolzen. Anschließend wird ein Iridiumstab in die Schmelze getaucht und die Temperatur der Schmelze so lange erniedrigt, bis sich um den Iridiumstab herum ein Kristallisat bildet. Das Kristallisat wird mit einer Geschwindigkeit von 5 mm/h von der Schmelzoberfläche weg nach oben gezogen. Der Wachstumsvorgang wird unterbrochen, wenn die Hälfte der Ausgangsschmelze kristalliert ist. Nach dem Abkühlen auf Raumtemperatur wird das Kristallisat röntgenographisch auf Phasenreinheit untersucht und die Gitterkonstante des Kristallisats gemessen.

Die Gitterkonstante kann nach der aus Philips Journal of Research 33 (1978), Seiten 186 bis 202 bekannten Gleichung von Strocka et al. auch aus der Schmelzzusammensetzung berechnet werden.

Ein Vergleich zwischen der berechneten und gemessenen Gitterkonstante gibt erste Hinweise auf die Verteilungskoeffizienten der Kationen. Liegen beide Gitterkonstanten im Bereich der Fehlergrenzen von $\Delta a_o = \pm 1.10^{-3}$ nm, sind Verteilungskoeffizienten von nahe bei 1 zu erwarten. Zur genauen Bestimmung der Verteilungskoeffizienten werden Einkristalle aus Schmelzzusammensetzungen gezüchtet und ihre Kristallzusammensetzung wird untersucht.

Zur Züchtung von Einkristallen werden die Oxide der gewünschten Zusammensetzung gemischt, in Zylinderform gepreßt und bei 1500 °C in Sauerstoffatmosphäre gesintert.

Für einen Einkristall der Zusammensetzung z.B. $Gd_3Ga_{1,59}Gd_{0,01}Mg_{0,2}Hf_{0,2}Ga_3O_{12}$ werden 106,36 g $Gd_2O_3$; 83,86 g $Ga_2O_3$; 1,57 g MgO und 8,21 g $HfO_2$ (Gesamteinwaage 200 g) gemischt und wie oben beschrieben weiterbehandelt. Der Sinterkörper wird anschließend in einem Iridiumtiegel mit 40 mm Durchmesser und 40 mm Höhe bei einer Temperatur von etwa 1700 °C in einer geschlossenen Kristallziehapparatur aufgeschmolzen. Durch die Apparatur wird ein Gasgemisch, bestehend aus 50 % $N_2$ + 50% $CO_2$ geleitet. Als Impfkristall dient ein zylinderförmiger Einkristallstab mit der kristallographischen [111]-Richtung parallel zur Stabachse. Der Impfkristall wird zunächst in die Schmelze eingetaucht (Animpfen) und anschließend mit einer Geschwindigkeit von 5 mm/h von der Schmelzoberfläche weg nach oben gezogen. Der wachsende Kristall wird mit 20 $min^{-1}$ um seine Achse gedreht. Der Wachstumsprozeß wird über Gewichtsregelung in der Weise gesteuert, daß der Kristall zunächst konusförmig in die Breite wächst, bis der gewünschte Kristalldurchmesser von 20 mm erreicht ist.

Anschließend wird die Leistung des Generators so geregelt, daß der Kristall mit konstantem Durchmesser weiterwächst. Der Wachstumsprozeß wird beendet durch schnelles Abziehen des gewachsenen Kristalls von seiner Restschmelze. Anschließend wird der Kristall langsam auf Raumtemperatur abgekühlt.

Für die Bestimmung der Kristallzusammensetzungen und der Gitterkonstanten werden Scheiben vom Kristallanfang und Kristallende abgeschnitten, wobei zur Bestimmung der Kristallzusammensetzung die Röntgenfluoreszenzanalyse (Analysenfehler: ± 0,02 Formeleinheiten) eingesetzt wird.

Die Verteilungskoeffizienten der Kationen ergeben sich aus den Zusammensetzungen von Kristallanfang ($C_s$) und Schmelze ($C_l$) entsprechend der Gleichung:

$$k_{eff(kat)} = C_s/C_l.$$

Im folgenden wird die Herstellung von Mischkristallen aus Mischkristallgruppen (I bis III) mit mehreren Mischkristallsystemen beschrieben.

Mischkristallgruppe I mit der Zusammensetzung gemäß der allgemeinen Formel

$\{RE_{3-x}Ca_x\}[Ga_{2-x-y-2z}R_yMg_zHf_{x+z}](Ga_3)O_{12}$ mit

RE =     $Gd^{3+}$, $Tb^{3+}$, $Dy^{3+}$, $Y^{3+}$, $Er^{3+}$, mit
R =      In und/oder RE und mit

$$0 \leq x \leq 0,55$$
$$0,01 \leq y \leq 0,28$$
$$0 \leq z \leq 0,55$$
$$0,15 \leq x + z \leq 0,60.$$

Als Parameter für die Beschreibung der fünf Mischkristallsysteme der Mischkristallgruppe I dienen die Bindungslängen {A(1)-O} und [B-O] des Dodekaeder- und Oktaederplatzes. Die Bindungslängen werden mit Hilfe der hinten genannten Gleichungen (8) bis (11) berechnet. Umgekehrt können aus den Bindungslängen auch wiederum die Granatzusammensetzungen errechnet werden.

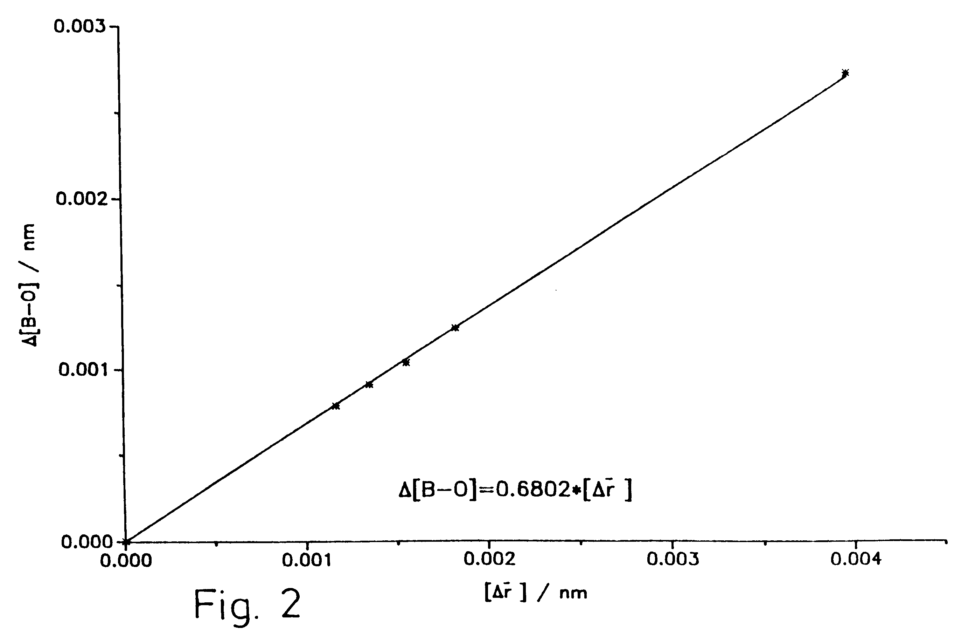

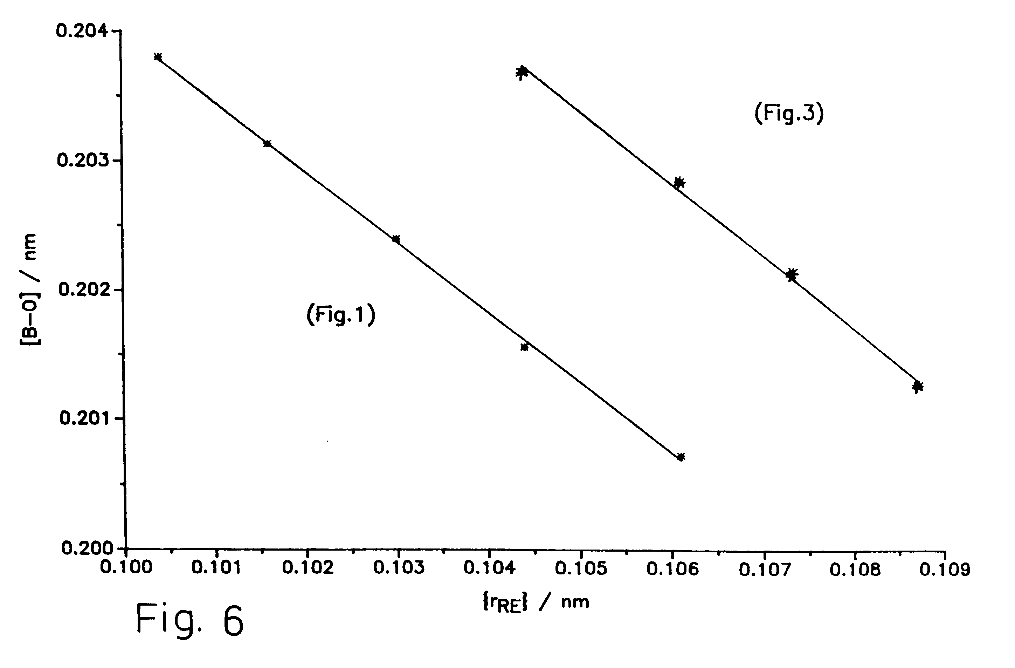

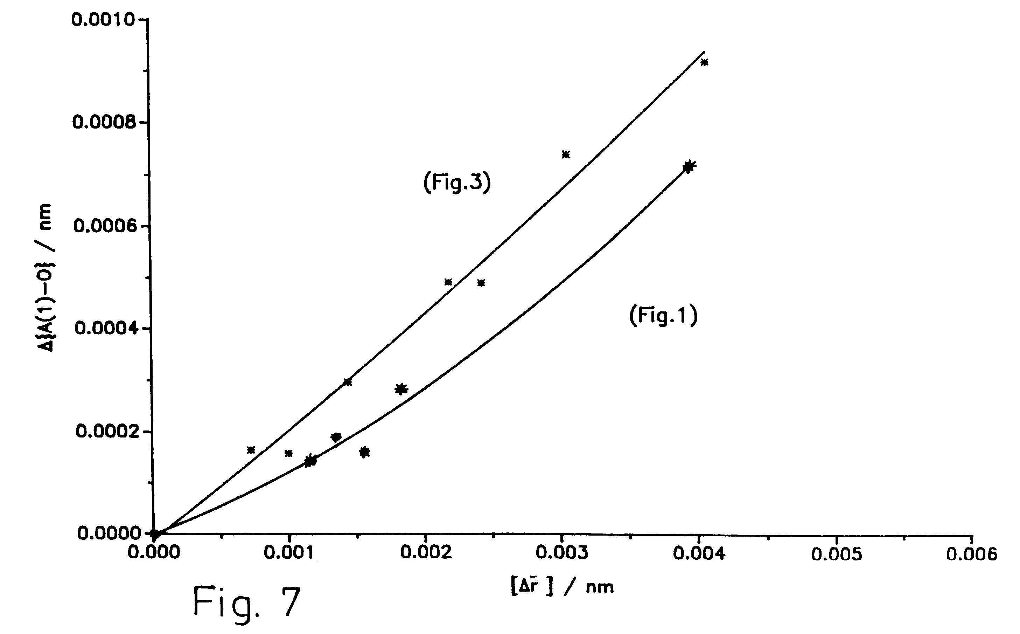

Die mittleren Bindungslängen von berechneten Granatzusammensetzungen mit Verteilungskoeffizienten nahe bei 1 sind mit den Kurven im Diagramm gemäß der Figur 1 dargestellt. Mit einem * sind in Figur 1 die mittleren Bindungslängen gezüchteter Kristalle gekennzeichnet. Diese Kennzeichnung gilt analog für die Diagramme gemäß den Figuren 2 bis 7. Bei allen Anfangsgliedern der Mischkristallreihen (Beginn der Kurven) steigen die Werte für die Bindungslängen sprunghaft an mit zunehmenden Radien der Seltenerdmetalle. Jede Kurve in Figur 1 gehört zu einem bestimmten Mischkristallsystem der Mischkristallgruppe I; die Mischkristallsysteme haben folgende Zusammensetzungen:

1. $\{Gd_{3-x}Ca_x\}[Ga_{2-x-y-2z}Gd_yMg_zHf_{x+z}](Ga_3)O_{12}$
(Gd-Kurve Figur 1).

Das Anfangsglied der Mischkristallreihe wird beschrieben durch die Formel:

$\{Gd_{2,85}Ca_{0,15}\}[Ga_{1,83}Gd_{0,02}Hf_{0,15}](Ga_3)O_{12}$,

worin die Bindungslängen für den Dodekaederplatz und den Oktaederplatz betragen:

$$\{A(1)\text{-}O\} = 0,2374 \text{ nm}, \quad [B\text{-}O] = 0,2008 \text{ nm}.$$

Das Endglied der Mischkristallreihe wird beschrieben durch die Formel:

$\{Gd_{3,00}\}[Ga_{1,59}Gd_{0,01}Mg_{0,20}Hf_{0,20}](Ga_3)O_{12}$,

worin die Bindungslängen für den Dodekaederplatz und den Oktaederplatz betragen:

$$\{A(1)\text{-}O\} = 0,2375 \text{ nm}, \quad [B\text{-}O] = 0,2016 \text{ nm}.$$

Die Mischkristallzusammensetzungen liegen in folgendem Bereich:
$0 \leq Ca \leq 0,15$; $0 \leq Mg \leq 0,20$; $0,15 \leq Hf \leq 0,20$ und $0,01 \leq [Gd] \leq 0,02$.

Für das Anfangs- und das Endglied ist jeweils die Schmelzzusammensetzung angegeben worden. Dies gilt auch für alle folgenden Ausführungsbeispiele.

2. $\{Tb_{3-x}Ca_x\}[Ga_{2-x-y-2z}Tb_xMg_zHf_{x+z}](Ga_3)O_{12}$
(Tb-Kurve Figur 1).

Das Anfangsglied der Mischkristallreihe wird beschrieben durch die Formel:

$\{Tb_{2,65}Ca_{0,35}\}[Ga_{1,62}Tb_{0,03}Hf_{0,35}](Ga_3)O_{12}$,

worin die Bindungslängen für den Dodekaederplatz und den Oktaederplatz betragen:

$$\{A(1)\text{-}O\} = 0,2370 \text{ nm}, \quad [B\text{-}O] = 0,2015 \text{ nm}.$$

Das Endglied der Mischkristallzeihe wird beschrieben durch die Formel:

$\{Tb_{2,95}Ca_{0,05}\}[Ga_{0,83}Tb_{0,02}Mg_{0,55}Hf_{0,60}](Ga_3)O_{12}$,

worin die Bindungslängen für den Dodekaederplatz und den Oktaederplatz betragen:

$$\{A(1)\text{-}O\} = 0,2377 \text{ nm}, \quad [B\text{-}O] = 0,2043 \text{ nm}.$$

10

Die Mischkristallzusammensetzungen liegen im folgenden Bereich:
$0,05 \leq Ca \leq 0,35$; $0 \leq Mg \leq 0,55$; $0,35 \leq Hf \leq 0,60$ und $0,02 \leq [Tb] \leq 0,03$.

3. $\{Dy_{3-x}Ca_x\}[Ga_{2-x-y-2z}Dy_yMg_zHf_{x+z}](Ga_3)O_{12}$
(Dy-Kurve Figur 1).

Das Anfangsglied der Mischkristallreihe wird beschrieben durch die Formel:

$\{Dy_{2,62}Ca_{0,38}\}[Ga_{1,51}Dy_{0,11}Hf_{0,38}](Ga_3)O_{12}$,

worin die Bindungslängen für den Dodekaederplatz und den Oktaederplatz betragen:

$$\{A(1)\text{-}O\} = 0,2367 \text{ nm}, [B\text{-}O] = 0,2022 \text{ nm}.$$

Das Endglied der Mischkristallreihe wird beschrieben durch die Formel:

$\{Dy_{2,75}Ca_{0,25}\}[Ga_{1,00}Dy_{0,05}Mg_{0,35}Hf_{0,60}](Ga_3)O_{12}$,

worin die Bindungslängen für den Dodekaederplatz und den Oktaederplatz betragen:

$$\{A(1)\text{-}O\} = 0,2370 \text{ nm}, [B\text{-}O] = 0,2036 \text{ nm}.$$

Die Mischkristallzusammensetzungen liegen in folgendem Bereich:
$0,25 \leq Ca \leq 0,38$; $0 \leq Mg \leq 0,35$; $0,38 \leq Hf \leq 0,60$ und $0,05 \leq [Dy] \leq 0,11$.

4. $\{Y_{3-x}Ca_x\} [Ga_{2-x-y-2z}Y_yMg_zHf_{x+z}] (Ga_3)O_{12}$
(Y-Kurve Figur 1):

Das Anfangsglied der Mischkristallreihe wird beschrieben durch die Formel:

$\{Y_{2,51}Ca_{0,49}\}[Ga_{1,33}Y_{0,18}Hf_{0,49}](Ga_3)O_{12}$, worin

die Bindungslängen für den Dodekaederplatz und den Oktaederplatz betragen:

$$\{A(1)\text{-}O\} = 0,2366 \text{ nm}, [B\text{-}O] = 0,2031 \text{ nm}.$$

Das Endglied der Mischkristallreihe wird beschrieben durch die Formel:

$\{Y_{2,60}Ca_{0,40}\}[Ga_{1,01}Y_{0,19}Mg_{0,20}Hf_{0,60}](Ga_3)O_{12}$

worin die Bindungslängen für den Dodekaederplatz und den Oktaederplatz betragen:

$$\{A(1)\text{-}O\} = 0,2369 \text{ nm}, [B\text{-}O] = 0,2044 \text{ nm}.$$

Die Mischkristallzusammensetzungen liegen in folgendem Bereich:
$0,39 \leq Ca \leq 0,49$; $0 \leq Mg \leq 0,20$; $0,49 \leq Hf \leq 0,60$ und $0,18 \leq [Y] \leq 0,19$.

5.
$\{Er_{3-x}Ca_x\}[Ga_{2-x-y-2z}(Er,In)_yMg_zHf_{x+z}](Ga_3)O_{12}$
(Er-Kurve Figur 1):

Das Anfangsglied der Mischkristallreihe wird beschrieben durch die Formel:

$\{Er_{2,45}Ca_{0,55}\}[Ga_{1,17}Er_{0,18}Hf_{0,55}In_{0,10}](Ga_3)O_{12}$,

worin die Bindungslängen für den Dodekaederplatz und den Oktaederplatz betragen:

$$\{A(1)\text{-}O\} = 0,2364 \text{ nm}, [B\text{-}O] = 0,2038 \text{ nm}.$$

Das Endglied der Mischkristallreihe wird beschrieben durch die Formel:

$\{Er_{2,51}Ca_{0,49}\}[Ga_{1,01}Er_{0,18}Mg_{0,11}Hf_{0,60}In_{0,10}](Ga_3)O_{12}$,

worin die Bindungslängen für den Dodekaederplatz und den Oktaederplatz betragen:

$\{A(1)-O\} = 0{,}2365$ nm, $[B-O] = 0{,}2044$ nm.

Die Mischkristallzusammensetzungen liegen im folgenden Bereich:
$0{,}49 \leq Ca \leq 0{,}55$; $0 \leq Mg \leq 0{,}11$; $0{,}55 \leq Hf \leq 0{,}60$; $[Er]$ bis $0{,}24$; $In$ bis $0{,}10$.

Der Verteilungskoeffizient von Erbium auf dem Oktaederplatz ist größer 1. Durch zusätzliche Substitution von Gallium durch Indium auf dem Oktaederplatz kann der Verteilungskoeffizient $k_{eff(Er)}$ etwas abgesenkt werden (vergleiche die Beispiele Nr. 12 und Nr. 13 in Tabelle Nr. 1).

Der enge Mischbereich und der Verteilungskoeffizient $k_{eff(Er)}$ größer 1 deuten darauf hin, daß das Wirtsgitter aus Erbium-Gallium-Granat die unterste Grenze bildet für die Mischkristallgruppe mit Ca, Mg und Hf als Substituenten.

In den Kurven gemäß Fig. 1 spiegelt sich der Einfluß des Wirtsgitters auf die Bindungslängen wieder. Für alle Anfangsglieder der Mischkristallsysteme der Mischkristallgruppe I gelten die empirischen Gleichungen:

$$\{A(1)-O\} = 0{,}30362 - 1{,}4571 \cdot \{r_{RE}\} + 7{,}8443 \cdot \{r_{RE}\}^2 \text{ (in Nanometer)} \qquad (8)$$
$$[B-O] = 0{,}25836 - 0{,}5436 \cdot \{r_{RE}\} \text{ (in Nanometer)}. \qquad (9)$$

Innerhalb der Mischkristallreihe steigen beide Bindungslängen kontinuierlich mit zunehmendem Mg- und Hf-Gehalt an. Die Zunahme der Bindungslängen ergibt sich aus den Gleichungen:

$$\Delta \{A(1)-O\} = 0{,}1024 \cdot [\Delta \bar{r}] + 19{,}8482 \cdot [\Delta \bar{r}]^2 \text{ (in Nanometer)} \qquad (10)$$
$$\Delta [B-O] = 0{,}6802 \cdot [\Delta \bar{r}] \text{ (in Nanometer)}. \qquad (11)$$

In den Gleichungen (10) und (11) bedeutet $[\Delta \bar{r}]$ die Radiendifferenz der mittleren Oktaederradien zwischen dem Anfangsglied und einer substituierten (Mg-haltigen) Zusammensetzung. Die berechnete Bindungslängendifferenz wird zu den mittleren Bindungslängen des Anfangsgliedes der Mischkristallreihe addiert.

Die Änderung der mittleren Bindungslängen des Tetraederplatzes in Abhängigkeit von der Zusammensetzung ist nicht dargestellt worden. Sie ist wesentlich geringer im Vergleich zu der der beiden anderen Gitterplätze und beträgt maximal nur $4 \cdot 10^{-4}$ nm. Für die Kationenbesetzung des Tetraederplatzes hat die Änderung der mittleren Bindungslängen auf dem Tetraederplatz (C-O) keine Bedeutung.

Die Grenzen der Mischkristallbildung sind erreicht, wenn die Funktionswerte der Kurven gemäß Figur 1 nicht mehr eingehalten werden können.

Hinsichtlich der den Dodekaederplatz besetzenden Seltenerdmetallionen ($RE^{3+}$) ist bekannt, daß bei den Seltenerdmetall-Gallium-Granaten Anteile dieser Seltenerdmetalle in Mengen größer 3 Formeleinheiten zusätzlich die Oktaederplätze im Gitter besetzen (hierzu wird z.B. hingewiesen auf J. of Cryst. Growth, 26 - (1974), Seiten 169 bis 170). Dieser Effekt wird auch bei den Mischkristallen auf Basis von Seltenerdmetall-Gallium-Granat beobachtet. Die Konzentration des Seltenerdmetallions auf dem Oktaederplatz steigt mit abnehmenden Radien der Seltenerdmetalle an.

Bei einer gekoppelten Substitution auf einem Gitterplatz gibt es in der Mischkristallgruppe I nur eine Granatzusammensetzung mit einem Verteilungskoeffizienten $k_{eff(kat)}$ nahe bei 1, nämlich das Endglied der Gadolinium-Mischkristallreihe mit der Zusammensetzung

$\{Gd_3\}[Ga_{1,59}Gd_{0,01}Mg_{0,20}Hf_{0,20}](Ga_3)O_{12}$.

Durch eine gekoppelte Substitution auf zwei Gitterplätzen (Ca und Hf) gibt es für jede Mischkristallreihe innerhalb der Mischkristallgruppe I eine Granatzusammensetzung mit Verteilungskoeffizienten nahe bei 1, nämlich alle Anfangsglieder der Mischkristallreihen.

Durch eine gekoppelte Substitution mit drei Kationen auf unterschiedlichen Gitterplätzen - Ca auf dem Dodekaederplatz und Mg + Hf auf dem Oktaederplatz - kann eine Mischkristallreihe mit mehreren Mischkristallsystemen mit Verteilungskoeffizienten $k_{eff(kat)}$ nahe bei 1 aufgebaut werden. Dies wird erreicht mit abnehmender Ca-Konzentration bei steigender Mg- und Hf-Konzentration.

Die Gitterkonstanten $a_o$ für die Granatzusammensetzungen gemäß der Mischkristallgruppe I sind in Figur 1 als Blockdiagramm am rechten Bildrand dargestellt. Charakteristisch für diese Mischkristallgruppe ist die Tatsache, daß alle Anfangsglieder der Mischkristallreihen eine Gitterkonstante von $a_o$ = 1,240 nm haben. Die Änderung der Gitterkonste $a_o$ durch die Radien der Seltenerdmetalle der Wirtsgitter wird durch den Einbau von entsprechenden Anteilen an $\{Ca^{2+}\}$-, $[Hf^{4+}]$- und $[RE^{3+}]$-Ionen kompensiert. Innerhalb einer Mischkristallreihe steigt die Gitterkonstante $a_o$ mit zunehmendem Mg- und Hf-Gehalt kontinuierlich an. Die maximale Änderung der Gitterkonstante ist in jedem System unterschiedlich. Im Mischkristallsystem für Terbium-Granat kann die Gitterkonstante $a_o$ im Bereich von 1,240 bis 1,246 nm variiert werden.

Die unterschiedlichen Mischkristallsysteme bieten daher die Möglichkeit, Einkristalle unterschiedlicher Zusammensetzung aber mit gleicher Gitterkonstante gezielt auszuwählen. Damit können also Einkristalle mit aufgrund ihrer Zusammensetzung ganz unterschiedlichen Eigenschaften jedoch gleicher Gitterkonstante gezüchtet werden.

Aus Schmelzen der beschriebenen Mischkristallsysteme wurden Einkristalle nach dem Czochralski-Verfahren hergestellt. Die Werte jeweils für die Schmelz- und Kristallzusammensetzung, die Bindungslängen der Gitterplätze, die Verteilungskoeffizienten $k_{eff(kat)}$, die Gitterkonstanten $a_o$ (berechnet und gemessen), die mittleren Radien $\bar{r}$ für die Kationen des Dodekaederplatzes und des Oktaederplatzes und die Abmessungen gezogener Kristalle (Länge L, Durchmesser $\varnothing$) für Mischkristalle der Mischkristallgruppe I ergeben sich aus Tabelle 1. Die mittleren Bindungslängen dieser Zusammensetzungen sind in Figur 1 mit einem Sternchen gekennzeichnet. Die Einkristalle haben Durchmesser im Bereich von 18 bis 20 mm und Kristallängen im Bereich von 40 bis 61 mm. Die Versetzungsdichte und Anzahl der Einschlüsse ist < 10 $cm^{-2}$. Die Kristallqualität der Einkristalle ist vergleichbar mit der von nicht substituierten Seltenerdmetall-Gallium-Granaten.

Tabelle 1

| Nr. | Schmelz(I)-, Kristallzusammensetzung(II), Bindungslängen {A(1)-O} {A(2)-O} [B-O] (C-O) in nm(III) und $k_{eff}$(VI) | | | | | | $a_{ober.}$ nm | $a_{omess}$ nm | {F} nm | [F] nm | L mm | ⌀ mm |
|---|---|---|---|---|---|---|---|---|---|---|---|---|
| | **Gadolinium-Granat** | | | | | | | | | | | |
| 1 | (I) {Gd2.85 Ca0.15} [Ga1.83 Gd0.02 | | | Hf0.15] | (Ga3.00) O12 | | 1.240 | | 0.10642 | 0.06208 | | |
| | (II) {Gd2.86 Ca0.14} [Ga1.83 Gd0.02 | | | Hf0.15] | (Ga3.00) O12 | | 1.240 | 1.2406 | | | | |
| | (III) {0.2374} {0.2468} [0.2008] | | | | (0.1852) | | | | | | 55 | 18 |
| | (IV) 1.00 0.93 1.00 | | | | 1.00 | | | | | | | |
| 2 | (I) {Gd3.00} [Ga1.59 Gd0.01 | | Mg0.20 | Hf0.20] | (Ga3.00) O12 | | 1.241 | | 0.10610 | 0.06326 | | |
| | (II) {Gd3.00} [Ga1.59 Gd0.01 | | Mg0.20 | Hf0.20] | (Ga3.00) O12 | | 1.241 | 1.2423 | | | | |
| | (III) {0.2375} {0.2467} [0.2016] | | | | (0.1851) | | | | | | 61 | 20 |
| | (IV) 1.00 1.00 | | 1.00 | 1.00 | | | | | | | | |
| | **Terbium-Granat** | | | | | | | | | | | |
| 3 | (I) {Tb2.65 Ca0.35} [Ga1.62 Tb0.03 | | | Hf0.35] | (Ga3.00) O12 | | 1.240 | | 0.10533 | 0.06322 | | |
| | (II) {Tb2.66 Ca0.34} [Ga1.61 Tb0.03 | | | Hf0.36] | (Ga3.00) O12 | | 1.240 | 1.2406 | | | | |
| | (III) {0.2370} {0.2462} [0.2015] | | | | (0.1851) | | | | | | 55 | 18 |
| | (IV) 1.00 0.97 0.99 | | | 1.03 | | | | | | | | |
| 4 | (I) {Tb2.83 Ca0.17} [Ga1.23 Tb0.02 | | Mg0.29 | Hf0.46] | (Ga3.00) O12 | | 1.242 | | 0.10485 | 0.06521 | | |
| | (II) {Tb2.83 Ca0.17} [Ga1.21 Tb0.02 | | Mg0.30 | Hf0.47] | (Ga3.00) O12 | | 1.242 | 1.2435 | | | | |
| | (III) {0.2373} {0.2461} [0.2028] | | | | (0.1850) | | | | | | 55 | 18 |
| | (III) 1.00 1.00 0.98 | | 1.03 | 1.02 | | | | | | | | |
| 5 | (I) {Tb2.95 Ca0.05} [Ga0.83 Tb0.02 | | Mg0.55 | Hf0.60] | (Ga3.00) O12 | | 1.244 | | 0.10453 | 0.06734 | | |
| | (II) {Tb2.94 Ca0.06} [Ga0.83 Tb0.02 | | Mg0.55 | Hf0.60] | (Ga3.00) O12 | | 1.244 | 1.2460 | | | | |
| | (III) {0.2377} {0.2462} [0.2043] | | | | (0.1849) | | | | | | 60 | 18 |
| | (IV) 1.00 1.20 1.00 | | 1.00 | 1.00 | | | | | | | | |
| | **Dysprosium-Granat** | | | | | | | | | | | |
| 6 | (I) {Dy2.62 Ca0.38} [Ga1.51 Dy0.11 | | | Hf0.38] | (Ga3.00) O12 | | 1.240 | | 0.10419 | 0.06457 | | |
| | (II) {Dy2.62 Ca0.38} [Ga1.50 Dy0.11 | | | Hf0.39] | (Ga3.00) O12 | | 1.240 | 1.2397 | | | | |
| | (III) {0.2367} {0.2455} [0.2022] | | | | (0.1850) | | | | | | 40 | 20 |
| | (IV) 1.00 1.00 0.99 | | | 1.03 | | | | | | | | |
| 7 | (I) {Dy2.75 Ca0.25} [Ga1.06 Dy0.05 | | Mg0.32 | Hf0.57] | (Ga3.00) O12 | | 1.241 | | 0.10378 | 0.06636 | | |
| | (II) {Dy2.74 Ca0.26} [Ga1.06 Dy0.06 | | Mg0.31 | Hf0.57] | (Ga3.00) O12 | | 1.241 | 1.2428 | | | | |
| | (III) {0.2369} {0.2455} [0.2034] | | | | (0.1849) | | | | | | 60 | 20 |
| | (IV) 1.00 1.04 1.00 | | 0.97 | 1.00 | | | | | | | | |
| 8 | (I) {Dy2.75 Ca0.25} [Ga1.00 Dy0.05 | | Mg0.35 | Hf0.60] | (Ga3.00) O12 | | 1.242 | | 0.10378 | 0.06668 | | |
| | (III) {0.2370} {0.2455} [0.2036] | | | | (0.1849) | | | | | | | |
| | **Yttrium-Granat** | | | | | | | | | | | |
| 9 | (I) {Y2.51 Ca0.49} [Ga1.33 Y0.18 | | | Hf0.49] | (Ga3.00) O12 | | 1.240 | | 0.10336 | 0.06606 | | |
| | (II) {Y2.52 Ca0.48} [Ga1.33 Y0.18 | | | Hf0.49] | (Ga3.00) O12 | | 1.240 | 1.2400 | | | | |
| | (III) {0.2366} {0.2451} [0.2031] | | | | (0.1849) | | | | | | 60 | 20 |
| | (IV) 1.00 0.98 1.00 | | | 1.00 | | | | | | | | |
| 10 | (I) {Y2.60 Ca0.40} [Ga1.13 Y0.19 | | Mg0.14 | Hf0.54] | (Ga3.00) O12 | | 1.241 | | 0.10304 | 0.06723 | | |
| | (II) {Y2.61 Ca0.39} [Ga1.13 Y0.19 | | Mg0.14 | Hf0.54] | (Ga3.00) O12 | | 1.241 | 1.2414 | | | | |
| | (III) {0.2367} {0.2451} [0.2039] | | | | (0.1848) | | | | | | 50 | 20 |
| | (IV) 1.00 0.98 1.00 | | 1.00 | 1.00 | | | | | | | | |
| 11 | (I) {Y2.60 Ca0.40} [Ga1.01 Y0.19 | | Mg0.20 | Hf0.60] | (Ga3.00) O12 | | 1.2420 | | 0.10304 | 0.06786 | | |
| | (III) {0.2369} {0.2452} [0.2044] | | | | (0.1848) | | | | | | | |
| | **Erbium-Granat** | | | | | | | | | | | |
| 12 | (I) {Er2.45 Ca0.55} [Ga1.27 Er0.18 | | | Hf0.55] | (Ga3.00) O12 | | 1.239 | | 0.10260 | 0.06627 | | |
| | (II) {Er2.47 Ca0.53} [Ga1.21 Er0.24 | | | Hf0.55] | (Ga3.00) O12 | | 1.240 | 1.2395 | | | | |
| | (III) {0.2361} {0.2446} [0.2031] | | | | (0.1848) | | | | | | 50 | 20 |
| | (III) 1.03 0.96 0.95 | | | 1.00 | | | | | | | | |
| 13 | (I) {Er2.45 Ca0.55} [Ga1.17 Er0.18 | In0.10 | | Hf0.55] | (Ga3.00) O12 | | 1.240 | | 0.10260 | 0.06718 | | |
| | (II) {Er2.46 Ca0.54} [Ga1.17 Er0.20 | In0.07 | | Hf0.56] | (Ga3.00) O12 | | 1.240 | 1.2406 | | | | |
| | (III) {0.2364} {0.2447} [0.2038] | | | | (0.1848) | | | | | | 58 | 18 |
| | (III) 1.01 0.98 1.00 | | | 1.02 | | | | | | | | |
| 14 | (I) {Er2.51 Ca0.49} [Ga1.01 Er0.18 | In0.10 | Mg0.11 | Hf0.60] | (Ga3.00) O12 | | 1.241 | | 0.10236 | 0.06804 | | |
| | (III) {0.2365} {0.2447} [0.2044] | | | | (0.1848) | | | | | | | |

Mischkristallgruppe II mit der Zusammensetzung gemäß der allgemeinen Formel:

$\{RE_{3-x}Ca_x\}[Ga_{2-x-y-2z}RE_yMg_zZr_{x+z}](Ga_3)O_{12}$ mit

RE = $Sm^{3+}$, $Eu^{3+}$, $Tb^{3+}$ und mit

14

$$0 \leq x \leq 0,58$$
$$0 \leq y \leq 0,10$$
$$0 \leq z \leq 0,50$$
$$0,15 \leq x + z \leq 0,68.$$

Die Mischkristallgruppe II besteht aus drei Mischkristallsystemen mit den Seltenerdmetallen
$RE = Sm^{3+}$, $Eu^{3+}$, $Tb^{3+}$.
Im Gegensatz zu der Mischkristallgruppe I enthalten diese Mischkristalle anstelle von Hafnium auf dem Oktaederplatz als Substituenten Zirkonium. Beide Mischkristallgruppen I und II zeigen vergleichbare Zusammenhänge im Hinblick auf die Mischkristallbildung. Als Parameter für die Beschreibung der drei Mischkristallsysteme der Mischkristallgruppe II dienen ebenfalls die Bindungslängen {A(1)-O} und [B-O] des Dodekaeder- und Oktaederplatzes. Die Bindungslängen werden mit Hilfe der hinten genannten Gleichungen (12) bis (15) berechnet.

Die Mischkristalle der drei Mischkristallsysteme der Mischkristallgruppe II haben folgende Zusammensetzungen:

1. $\{Tb_{3-x}Ca_x\}[Ga_{2-x-y-2z}Tb_yMg_zZr_{x+z}](Ga_3)O_{12}$
(Tb-Kurve Figur 3):

Das Anfangsglied der Mischkristallreihe wird beschrieben durch die Formel:

$\{Tb_{2,42}Ca_{0,58}\}[Ga_{1,34}Tb_{0,08}Zr_{0,58}](Ga_3)O_{12}$,

worin die Bindungslängen für den Dodekaederplatz und den Oktaederplatz betragen:

$$\{A(1)\text{-}O\} = 0,2383 \text{ nm}, [B\text{-}O] = 0,2037 \text{ nm}.$$

Das Endglied der Mischkristallreihe wird beschrieben durch die Formel:

$\{Tb_{2,48}Ca_{0,52}\}[Ga_{1,22}Tb_{0,10}Mg_{0,08}Zr_{0,60}](Ga_3)O_{12}$,

worin die Bindungslängen für den Dodekaederplatz und den Oktaederplatz betragen:

$$\{A(1)\text{-}O\} = 0,2384 \text{ nm}, [B\text{-}O] = 0,2043 \text{ nm}.$$

Die Mischkristallzusammensetzungen liegen in folgendem Bereich:
$0,50 \leq Ca \leq 0,58$; $0 \leq Mg \leq 0,08$; $0,58 \leq Zr \leq 0,60$ und $0,07 \leq [Tb] \leq 0,10$.

2. $\{Eu_{3-x}Ca_x\}[Ga_{2-x-y-2z}Eu_yMg_zZr_{x+z}](Ga_3)O_{12}$
(Eu-Kurve Figur 3):

Das Anfangsglied der Mischkristallreihe wird beschrieben durch die Formel:

$\{Eu_{2,68}Ca_{0,32}\}[Ga_{1,66}Eu_{0,02}Zr_{0,32}](Ga_3)O_{12}$,

worin die Bindungslängen für den Dodekaederplatz und den Oktaederplatz betragen:

$$\{A(1)\text{-}O\} = 0,2387 \text{ nm}, [B\text{-}O] = 0,2021 \text{ nm}.$$

Das Endglied der Mischkristallreihe wird beschrieben durch die Formel:

$\{Eu_{2,94}Ca_{0,06}\}[Ga_{0,95}Eu_{0,01}Mg_{0,49}Zr_{0,55}](Ga_3)O_{12}$,

worin die Bindungslängen für den Dodekaederplatz und den Oktaederplatz betragen:

$$\{A(1)\text{-}O\} = 0,2397 \text{ nm}, [B\text{-}O] = 0,2050 \text{ nm}.$$

15

Die Mischkristallzusammensetzungen liegen in folgendem Bereich: $0{,}06 \leq Ca \leq 0{,}32$; $0 \leq Mg \leq 0{,}50$; $0{,}32 \leq Zr \leq 0{,}56$ und $0{,}01 \leq [Eu] \leq 0{,}02$.

3. $\{Sm_{3-x}Ca_x\}[Ga_{2-x-y-2z}Sm_yMg_zZr_{x+y}](Ga_3)O_{12}$
(Sm-Kurve Figur 3).

Das Anfangsglied der Mischkristallreihe wird beschrieben durch die Formel:

$\{Sm_{2,85}Ca_{0,15}\}[Ga_{1,85}Zr_{0,15}](Ga_3)O_{12}$, worin die

Bindungslängen für den Dodekaederplatz und den Oktaederplatz betragen:

$$\{A(1)\text{-}O\} = 0{,}2390 \text{ nm}, \quad [B\text{-}O] = 0{,}2013 \text{ nm}.$$

Das Endglied der Mischkristallreihe wird beschrieben durch die Formel:

$\{Sm_3\}[Ga_{1,60}Mg_{0,20}Zr_{0,20}](Ga_3)O_{12}$,

worin die Bindungslängen für den Dodekaederplatz und den Oktaederplatz betragen:

$$\{A(1)\text{-}O\} = 0{,}2393 \text{ nm}, \quad [B\text{-}O] = 0{,}2022 \text{ nm}.$$

Die Mischkristallzusammensetzungen liegen in folgendem Bereich: $0 \leq Ca \leq 0{,}15$; $0 \leq Mg \leq 0{,}20$ $0{,}15 \leq Zr \leq 0{,}20$ und $0 \leq [Sm] \leq 0{,}01$.

Die Bindungslängen des Dodekaeder- und Oktaederplatzes von Granatzusammensetzungen mit Verteilungskoeffizienten $k_{eff(kat)}$ nahe bei 1 für Kristalle der Mischkristallgruppe II sind im Diagramm der Figur 3 dargestellt. Sowohl die Bindungslänge für den Dodekaederplatz als auch die Bindungslänge für den Oktaederplatz steigen an mit zunehmenden Radien der Seltenerdmetalle und mit zunehmender Mg- bzw. Zr-Konzentration.

Die Berechnung der mittleren Bindungslängen aller Anfangsglieder der Mischkristallreihen für Mischkristalle der Mischkristallgruppe II kann nach den Gleichungen erfolgen:

$$\{A(1)\text{-}O\} = 0{,}25119 - 0{,}4027 \cdot \{r_{RE}\} + 2{,}6730 \cdot \{r_{RE}\}^2 \text{(in Nanometer)} \tag{12}$$
$$[B\text{-}O] = 0{,}26266 - 0{,}5645 \cdot \{r_{RE}\} \text{ (in Nanometer)}. \tag{13}$$

Für die mittleren Bindungslängen innerhalb einer Mischkristallreihe für Mischkristalle der Mischkristallgruppe II gilt:

$$\Delta \{A(1)\text{-}O\} = 0{,}2070 \cdot [\Delta \bar{r}] + 6{,}0593 \cdot [\Delta \bar{r}]^2 \text{ (in Nanometer)} \tag{14}$$
$$\Delta [B\text{-}O] = 0{,}6961 \cdot [\Delta \bar{r}] \text{ (in Nanometer)}. \tag{15}$$

Die Faktoren der Gleichungen 12 bis 15 für die Berechnung der Bindungslängen bzw. der mittleren Bindungslängen für Mischkristalle der Mischkristallgruppe II sind im Vergleich zu den Faktoren der Gleichungen (8) bis (11) für die Berechnung der Bindungslängen bzw. der mittleren Bindungslängen für Mischkristalle der Mischkristallgruppe I etwas verändert. Diese Änderung ist zurückzuführen auf den unterschiedlichen Einfluß von Hafnium einerseits und Zirkonium andererseits auf die mittleren Bindungslängen.

Die Gitterkonstanten $a_o$ für Mischkristalle der Mischkristallgruppe II können im Bereich von 1,245 bis 1,252 nm variiert werden. Alle Anfangsglieder der entsprechenden Mischkristallreihen haben eine Gitterkonstante von $a_o = 1{,}245$ nm (vergleiche Figur 3). Auch hier zeigt sich, daß Mischkristalle aus Schmelzen oxidischer Vielstoffsysteme mit unterschiedlicher Zusammensetzung jedoch mit gleicher Gitterkonstante gezüchtet werden können. Es können also Einkristalle mit wegen ihrer unterschiedlichen Zusammensetzung sehr unterschiedlichen physikalischen Eigenschaften erhalten werden bei gleicher Gitterkonstante.

Dies gilt nicht nur für Einkristalle mit kubischer Kristallstruktur wie z.B. Granate, sondern für Mischkristalle aus Schmelzen oxidischer Vielstoffsysteme ganz allgemein. Für technische Anwendungen sind beispielsweise Mischkristalle mit Spinell- oder Perowskitstruktur ebenso von Interesse wie Mischkristalle mit Granatstruktur.

Aus Schmelzen der drei Mischkristallsysteme gemäß der Mischkristallgruppe II wurden Einkristalle nach dem Czochralski-Verfahren hergestellt. Die Werte jeweils für die Schmelz- und Kristallzusammensetzung, die Bindungslängen der Gitterplätze, die Verteilungskoeffizienten $k_{eff(kat)}$, die Gitterkonstanten $a_o$ (berechnet und gemessen), die mittleren Radien $\bar{r}$ für die Kationen des Dodekaeder- und des Oktaederplatzes und die Abmessungen gezogener Einkristalle (Länge L, Durchmesser ⌀) für Mischkristalle der Mischkristallgruppe II ergeben sich aus Tabelle 2.

Die mittleren Bindungslängen dieser Zusammensetzungen sind in Figur 3 mit einem Sternchen gekennzeichnet. Die Einkristalle haben Durchmesser von 20 bis 100 mm und Kristallängen von 55 bis 150 mm. Die Versetzungsdichte und Anzahl von Einschlüssen ist < 10 cm$^{-2}$.

### Tabelle 2

| Nr. | | Schmelz(I)-, Kristallzusammensetzung(II),Bindungslängen {A(1)-O} {A(2)-O} [B-O] (C-O) in nm(III) und $k_{eff}$(VI) | | | | $a_{ober.}$ nm | $a_{mess}$ nm | $\{\bar{r}\}$ nm | $[\bar{r}]$ nm | L mm | ⌀ mm |
|---|---|---|---|---|---|---|---|---|---|---|---|
| | | **Samarium Granat** | | | | | | | | | |
| 15 | (I) | {Sm2.85 Ca0.15} | [Ga1.85 | | Zr0.15] (Ga3.00) O12 | 1.245 | | 0.10888 | 0.06201 | | |
| | (II) | {Sm2.86 Ca0.14} | [Ga1.85 | | Zr0.15] (Ga3.00) O12 | 1.245 | 1.2454 | | | | |
| | (III) | {0.2390} {0.2487} | [0.2013] | | (0.1853) | | | | | | |
| | (IV) | 1.00 0.93 | 1.00 | | 1.00 | | | | | | |
| 16 | (I) | {Sm3.00} | [Ga1.60 | Mg0.20 Zr0.20] (Ga3.00) O12 | | 1.247 | | 0.10870 | 0.06345 | | |
| | (II) | {Sm3.00} | [Ga1.59 Sm0.01 | Mg0.20 Zr0.20] (Ga3.00) O12 | | 1.247 | 1.2476 | | | 100 | 35 |
| | (III) | {0.2393} {0.2487} | [0.2022] | | (0.1853) | | | | | | |
| | (IV) | 1.00 0.99 | | 1.00 1.00 | | | | | | | |
| | | **Europium Granat** | | | | | | | | | |
| 17 | (I) | {Eu2.68 Ca0.32} | [Ga1.66 Eu0.02 | | Zr0.32] (Ga3.00) O12 | 1.245 | | 0.10784 | 0.06350 | | |
| | (II)* | {Eu2.68 Ca0.32} | [Ga1.65 Eu0.02 | | Zr0.33] (Ga3.00) O12 | 1.245 | 1.2460 | | | | |
| | (III) | {0.2387} {0.2481} | [0.2021] | | (0.1852) | | | | | | |
| | (IV) | 1.00 1.00 | 0.99 | | 1.03 | | | | | | |
| 18 | (I) | {Eu2.882 Ca0.118} | [Ga1.236 | Mg0.323 Zr0.441] (Ga3.00) O12 | | 1.248 | | 0.10750 | 0.06575 | | |
| | (II) | {Eu2.89 Ca0.11} | [Ga1.20 Eu0.01 | Mg0.34 Zr0.45] (Ga3.00) O12 | | 1.248 | 1.2492 | | | 55 | 20 |
| | (III) | {0.2392} {0.2481} | [0.2037] | | (0.1851) | | | | | | |
| | (IV) | 1.01 0.93 | 0.97 | 1.05 1.02 | | | | | | | |
| 19 | (I) | {Eu2.94 Ca0.06} | [Ga0.95 Eu0.01 | Mg0.49 Zr0.55] (Ga3.00) O12 | | 1.251 | | 0.10730 | 0.06856 | | |
| | (II)* | {Eu2.94 Ca0.06} | [Ga0.93 Eu0.01 | Mg0.50 Zr0.56] (Ga3.00) O12 | | 1.251 | 1.2517 | | | | |
| | (III) | {0.2397} {0.2483} | [0.2050] | | (0.1851) | | | | | | |
| | (IV) | 1.00 1.00 | 0.97 | 1.02 1.02 | | | | | | | |
| | | **Terbium Granat** | | | | | | | | | |
| 25 | (I) | {Tb2.42 Ca0.58} | [Ga1.34 Tb0.08 | | Zr0.58] (Ga3.00) O12 | 1.245 | | 0.10595 | 0.06617 | | |
| | (II)* | {Tb2.44 Ca0.56} | [Ga1.35 Tb0.07 | | Zr0.58] (Ga3.00] O12 | 1.245 | 1.2452 | | | | |
| | (III) | {0.2383} {0.2470} | [0.2037] | | (0.1850) | | | | | | |
| | (IV) | 1.01 0.97 | 1.01 | | 1.00 | | | | | | |
| 26 | (I) | {Tb2.48 Ca0.52} | [Ga1.22 Tb0.10 | Mg0.08 Zr0.60] (Ga3.00) O12 | | 1.246 | | 0.10579 | 0.06706 | | |
| | (II) | {Tb2.50 Ca0.50} | [Ga1.22 Tb0.10 | Mg0.08 Zr0.60] (Ga3.00) O12 | | 1.246 | 1.2455 | | | 60 | 20 |
| | (III) | {0.2384} {0.2470} | [0.2043] | | (0.1850) | | | | | | |
| | (IV) | 1.01 0.96 | 1.00 | 1.00 1.00 | | | | | | | |

Mischkristallgruppe III mit der Zusammensetzung gemäß der allgemeinen Formel

$$\{RE_{3-u-v}Ca_uMg_v\}[In_{2-w-x}Mg_wZr_x](Ga_{3-y-z}Ge_yMg_z)O_{12}$$

mit

RE = $Pr^{3+}$ oder $Nd^{3+}$ und mit

$$0 \leq u \leq 0{,}60$$
$$0 \leq v \leq 0{,}06$$
$$1{,}25 \leq w \leq 1{,}50$$
$$0 \leq x \leq 0{,}50$$
$$1{,}32 \leq y \leq 1{,}60$$

$$0,03 \leqq z \leqq 0,15$$

Die Mischkristallbildung erfolgt bei dieser Mischkristallgruppe über eine gekoppelte Substitution auf drei unterschiedlichen Gitterplätzen (Dodekaederplatz, Oktaederplatz, Tetraederplatz) nach dem gleichen Prinzip wie bei den vorne beschriebenen Mischkristallgruppen I und II. Innerhalb der Mischkristallgruppe III wurden folgende Mischkristallsysteme hergestellt:

1. $\{Pr_{3-u-v}Ca_uMg_v\}[In_{2-w-x}Mg_wZr_x](Ga_{3-y-z}Ge_yMg_z)O_{12}$.

Das Anfangsglied der Mischkristallreihe wird beschrieben durch die Formel:

$$\{Pr_{2,97}Mg_{0,03}\}[In_{0,67}Mg_{1,33}](Ga_{1,42}Ge_{1,47}Mg_{0,11})O_{12},$$

worin die Bindungslängen für den Dodekaederplatz und den Oktaederplatz betragen:

$$\{A(1)\text{-}O\} = 0,2453 \text{ nm}, \ [B\text{-}O] = 0,2108 \text{ nm}.$$

Das Endglied der Mischkristallreihe wird beschrieben durch die Formel:

$$\{Pr_{2,77}Ca_{0,20}Mg_{0,03}\}[In_{0,40}Mg_{1,35}Zr_{0,25}](Ga_{1,37}Ge_{1,48}Mg_{0,15})O_{12},$$

worin die Bindungslängen für den Dodekaederplatz und den Oktaederplatz betragen:

$$\{A(1)\text{-}O\} = 0,2451 \text{ nm}, \ [B\text{-}O] = 0,2103 \text{ nm}.$$

Die Mischkristallzusammensetzungen liegen in folgendem Bereich:
$0 \leq Ca \leq 0,20$; $0,03 \leq \{Mg\} \leq 0,06$; $1,33 \leq [Mg] \leq 1,36$; $0 \leq Zr \leq 0,25$; $1,47 \leq Ge \leq 1,50$; $0,08 \leq (Mg) \leq 0,15$.

2. $\{Nd_{3-u-v}Ca_uMg_v\}[In_{2-w-x}Mg_wZr_x](Ga_{3-y-z}Ge_yMg_z)O_{12}$.

Das Anfangsglied der Mischkristallreihe wird beschrieben durch die Formel:

$$\{Nd_{2,97}Mg_{0,03}\}[In_{0,74}Mg_{1,26}](Ga_{1,63}Ge_{1,33}Mg_{0,04})O_{12},$$

worin die Bindungslängen für den Dodekaederplatz und den Oktaederplatz betragen:

$$\{A(1)\text{-}O\} = 0,2443 \text{ nm}, \ [B\text{-}O] = 0,2107 \text{ nm}.$$

Die Werte jeweils für die Schmelz- und Kristallzusammensetzung, die Bindungslängen der Gitterplätze, die Verteilungskoeffizienten $k_{eff(kat)}$, die Gitterkonstanten $a_o$ (berechnet und gemessen), die mittleren Radien $\bar{r}$ für die Kationen des Dodekaeder-, des Oktaeder- und des Tetraederplatzes und die Abmessungen gezogener Kristalle (Länge L, Durchmesser $\varnothing$) für Mischkristalle der Mischkristallgruppe III ergeben sich aus Tabelle 3.

Die Gitterkonstanten $a_o$ für Mischkristalle der Mischkristallgruppe III können im Bereich von 1,264 bis 1,2672 nm variiert werden. Die Einkristalle haben Durchmesser von 15 bis 18 mm und Kristallängen von 35 bis 62 mm. Die Versetzungsdichte und Anzahl von Einschlüssen ist $< 10 \text{ cm}^{-2}$.

Tabelle 3

| Nr. | | Schmelz(I)-, Kristallzusammensetzung(II), Bindungslängen {A(1)-O} {A(2)-O} [B-O] (C-O) in nm(III) und $k_{eff}$(IV) | $a_{0 ber.}$ nm | $a_{0 mess}$ nm | {r} nm | [r] nm | (r̄) nm | L mm | Ø mm |
|---|---|---|---|---|---|---|---|---|---|
| **27** | | **Praseodym-Granat** | | | | | | | |
| | (I) | {Pr$_{2.97}$ Mg$_{0.03}$} [In$_{0.67}$ Mg$_{1.33}$] (Ga$_{1.42}$ Ge$_{1.47}$ Mg$_{0.11}$) O$_{12}$ | 1.267 | | | | | | |
| | (II) | {Pr$_{2.94}$ Mg$_{0.06}$} [In$_{0.64}$ Mg$_{1.36}$] (Ga$_{1.42}$ Ge$_{1.50}$ Mg$_{0.08}$) O$_{12}$ | 1.266 | 1.2672 | 0.11345 | 0.07442 | 0.04345 | 35 | 15 |
| | (III) | {0.2453} {0.2543} [0.2108] (0.1816) | | | | | | | |
| | (IV) | 0.99 0.96 1.02 | | | | | | | |
| **28** | | | | | | | | | |
| | (I) | {Pr$_{2.77}$ Ca$_{0.20}$ Mg$_{0.03}$} [In$_{0.40}$ Mg$_{1.35}$ Zr$_{0.25}$] (Ga$_{1.37}$ Ge$_{1.48}$ Mg$_{0.15}$) O$_{12}$ | 1.266 | | | | | | |
| | (II) | {Pr$_{2.77}$ Ca$_{0.20}$ Mg$_{0.03}$} [In$_{0.41}$ Mg$_{1.34}$ Zr$_{0.23}$] (Ga$_{1.36}$ Ge$_{1.50}$ Mg$_{0.14}$) O$_{12}$ | 1.266 | 1.2672 | 0.11337 | 0.07375 | 0.04355 | 40 | 15 |
| | (III) | {0.2451} {0.2541} [0.2103] (0.1817) | | | | | | | |
| | (IV) | 1.00 1.03 1.00 0.92 0.99 1.01 | | | | | | | |
| **29** | | **Neodym-Granat** | | | | | | | |
| | (I) | {Nd$_{2.97}$ Mg$_{0.03}$} [In$_{0.74}$ Mg$_{1.26}$] (Ga$_{1.63}$ Ge$_{1.33}$ Mg$_{0.04}$) O$_{12}$ | 1.264 | | | | | | |
| | (II) | {Nd$_{2.96}$ Mg$_{0.04}$} [In$_{0.75}$ Mg$_{1.25}$] (Ga$_{1.65}$ Ge$_{1.32}$ Mg$_{0.03}$) O$_{12}$ | 1.264 | 1.2665 | 0.11177 | 0.07467 | 0.04359 | 62 | 18 |
| | (III) | {0.2443} {0.2531} [0.2107] (0.1816) | | | | | | | |
| | (IV) | 1.00 1.01 0.99 1.01 0.99 | | | | | | | |

Mit dem Verfahren gemäß der Erfindung ergibt sich der Vorteil, daß es möglich ist, sowohl homogene, große Einkristalle als auch polykristallines Material mit homogenen Kristalliten aus oxidischen Vielstoffsystemen herzustellen. Durch geeignete, vom Verhältnis der Bindungslänge der Kationen auf dem ersten Gitterplatz mit der höchsten Anzahl benachbarter Sauerstoffionen zur Bindungslänge der Kationen auf dem zweiten Gitterplatz mit der nächst niedrigeren Anzahl benachbarter Sauerstoffionen bestimmte Auswahl der Zusammensetzung können die Verteilungskoeffizienten $k_{eff(kat)}$ der Kationen auf etwa 1 eingestellt werden, es ist also möglich, gezielt homogene Mischkristalle zu züchten mit unterschiedlichster Zusammensetzung. Die Gitterkonstante a für die gezüchteten Mischkristalle ist über einen weiten Bereich kontinuierlich einstellbar. Es können jedoch ebensogut Mischkristalle mit jeweils gleicher Gitterkonstante, jedoch ganz unterschiedlicher Zusammensetzung und damit unterschiedlichen Eigenschaften gezüchtet werden. Dies ist nicht nur von Bedeutung hinsichtlich angepaßter Gitterkonstanten eines einkristallinen Substrats an abzuscheidende einkristalline Schichten, also hinsichtlich kristallographischer Eigenschaften, sondern auch hinsichtlich der Variierbarkeit weiterer physikalischer, wie z.B. optischer und elektrooptischer, magnetischer, elektrischer Eigenschaften des zu züchtenden Mischkristalls. Zu den elektrischen Eigenschaften sind alle elektrischen Transporteigenschaften zu zählen, wie z.B. Supraleitung, metallische Leitung, halbleitende und isolierende Eigenschaften.

## Patentansprüche

1. Verfahren zur Züchtung von Mischkristallen mit mindestens zwei Gitterplätzen mit jeweils einer unterschiedlichen Anzahl benachbarter Sauerstoffionen aus Schmelzen oxidischer Vielstoffsysteme,
dadurch gekennzeichnet,
daß homogene Mischkristalle mit Granat-, Perowskit- oder Spinell-Struktur gezüchtet werden, derart, daß die Kationen für die Besetzung des ersten Gitterplatzes mit der höchsten Anzahl benachbarter Sauerstoffionen und für die Besetzung des zweiten Gitterplatzes mit der nächst niedrigeren Anzahl benachbarter Sauerstoffionen so ausgewählt werden, daß das Verhältnis der mittleren, für den ersten Gitterplatz berechneten Bindungslänge der Kationen auf dem ersten Gitterplatz zur mittleren, für den zweiten Gitterplatz berechneten Bindungslänge der Kationen auf dem zweiten Gitterplatz im Bereich von 0,7 bis 1,5 liegt.

2. Verfahren nach Anspruch 1,
dadurch gekennzeichnet,
daß das Verhältnis der mittleren, für den ersten Gitterplatz berechneten Bindungslänge der Kationen auf dem ersten Gitterplatz zur mittleren, für den zweiten Gitterplatz berechneten Bindungslänge der Kationen auf dem zweiten Gitterplatz im Bereich von 1,16 bis 1,24 liegt.

3. Verfahren zur Züchtung von Mischkristallen auf Basis von Seltenerdmetall-Gallium-Granat nach den Ansprüchen 1 und 2,
dadurch gekennzeichnet,
daß die Zusammensetzung der die Schmelze bildenden Komponenten zur Züchtung homogener Mischkristalle in Abhängigkeit jeweils der Bindungslängen des Dodekaederplatzes {A(1)-O} und des Oktaederplatzes [B-O] so ausgewählt wird, daß die mittlere, für den Dodekaederplatz berechnete Bindungslänge des Dodekaederplatzes {A(1)-O} im Bereich von 0,2361 nm bis 0,2453 nm und die mittlere, für den Oktaederplatz berechnete Bindungslänge des Oktaederplatzes [B-O] im Bereich von 0,2008 nm bis 0,2108 nm liegt.

4. Verfahren nach Anspruch 3,
dadurch gekennzeichnet, daß die Zusammensetzung der die Schmelze bildenden Komponenten in Abhängigkeit jeweils der mittleren, berechneten Bindungslängen des Dodekaederplatzes {A(1)-O} und des Oktaederplatzes [B-O] so ausgewählt wird, daß die mittlere, für den Dodekaederplatz berechnete Bindungslänge des Dodekaederplatzes {A(1)-O} im Bereich von 0,2361 nm bis 0,2377 nm und die mittlere, für den Oktaederplatz berechente Bindungslänge des Oktaederplatzes [B-O] im Bereich von 0,2008 nm bis 0,2044 nm liegt.

5. Verfahren nach Anspruch 3,
dadurch gekennzeichnet, daß die Zusammensetzung der die Schmelze bildenden Komponenten in Abhängigkeit jeweils der mittleren, berechneten Bindungslängen des Dodekaederplatzes {A(1)-O} und des Oktaederplatzes [B-O] so ausgewählt wird, daß die mittlere, für den Dodekaederplatz berechnete Bindungslänge des Dodekaederplatzes {A(1)-O} im Bereich von 0,2383 nm bis 0,2397 nm und die mittlere, für den Oktaederplatz berechnete Bindungslänge des Oktaederplatzes [B-O] im Bereich von 0,2013 nm bis 0,2052 nm liegt.

**6.** Verfahren nach Anspruch 3,
dadurch gekennzeichnet,
daß die Zusammensetzung der die Schmelze bildenden Komponenten in Abhängigkeit jeweils der mittleren, berechneten Bindungslängen des Dodekaederplatzes {A(1)-O} und des Oktaederplatzes [B-O] so ausgewählt wird, daß die mittlere, für den Dodekaederplatz berechnete Bindungslänge des Dodekaederplatzes {A(1)-O} im Bereich von 0,2443 nm bis 0,2453 nm und die mittlere, für den Oktaederplatz berechnete Bindungslänge des Oktaederplatzes [B-O] im Bereich von 0,2103 nm bis 0,2108 nm liegt.

**7.** Verfahren nach den Ansprüchen 1 bis 6,
dadurch gekennzeichnet,
daß für die Besetzung des ersten Gitterplatzes Kationen aus der Gruppe
$K^{1+}$, $Ba^{2+}$, $Pb^{2+}$, $Sr^{2+}$, $La^{3+}$, $Na^{1+}$, $Ce^{3+}$, $Pr^{3+}$, $Bi^{3+}$, $Ca^{2+}$, $Nd^{3+}$, $Cd^{2+}$, $Th^{4+}$, $Sm^{3+}$, $Eu^{3+}$, $Gd^{3+}$, $Tb^{3+}$, $Dy^{3+}$, $Ho^{3+}$, $Y^{3+}$, $Er^{3+}$, $Tm^{3+}$, $Yb^{3+}$, $Lu^{3+}$, $Ce^{4+}$, $Mn^{2+}$, $Cu^{2+}$, $In^{3+}$, $Li^{1+}$, $Fe^{2+}$, $Zn^{2+}$, $Co^{2+}$, $Mg^{2+}$, $Sc^{3+}$, $Sn^{4+}$, $Ti^{4+}$, $Ni^{2+}$in das System eingeführt werden.

**8.** Verfahren nach den Ansprüchen 1 bis 6,
dadurch gekennzeichnet,
daß für die Besetzung des zweiten Gitterplatzes Kationen aus der Gruppe
$Sm^{3+}$, $Eu^{3+}$, $Gd^{3+}$, $Tb^{3+}$, $Dy^{3+}$, $Ho^{3+}$, $Y^{3+}$, $Er^{3+}$, $Tm^{3+}$, $Yb^{3+}$, $Lu^{3+}$, $Mn^{2+}$, $In^{3+}$, $Fe^{2+}$, $Pb^{4+}$, $Li^{1+}$, $Sc^{3+}$, $Zr^{4+}$, $Co^{2+}$, $Zn^{2+}$, $Cu^{2+}$, $Mg^{2+}$, $Hf^{4+}$, $Sn^{4+}$, $Ni^{2+}$, $Rh^{3+}$, $Mn^{3+}$, $Fe^{3+}$, $V^{3+}$, $Ta^{5+}$, $Nb^{5+}$, $Pt^{4+}$, $Ru^{4+}$, $Cr^{3+}$, $Ga^{3+}$, $Co^{3+}$, $Ti^{4+}$, $Ni^{3+}$, $Cu^{3+}$, $Al^{3+}$, $Mn^{4+}$, $Ge^{4+}$,
in das System eingeführt werden.

**9.** Verfahren nach mindestens einem der Ansprüche 1 bis 8,
dadurch gekennzeichnet,
daß Mischkristalle gezüchtet werden mit einer Zusammensetzung gemäß der allgemeinen Formel

$$\{RE_{3-x}Ca_x\}[Ga_{2-x-y-2z}R_yMg_zHf_{x+z}](Ga_3)O_{12},$$

worin sind
RE = ein Kation aus der Gruppe $Gd^{3+}$, $Tb^{3+}$, $Dy^{3+}$, $Ho^{3+}$, $Y^{3+}$, $Er^{3+}$,
R = In und/oder RE und

$$0 \leq x \leq 0,55$$
$$0,01 \leq y \leq 0,28$$
$$0 \leq z \leq 0,55$$
$$0,15 \leq x + z \leq 0,60.$$

**10.** Verfahren nach Anspruch 9,
dadurch gekennzeichnet,
daß die Zusammensetzung der Mischkristalle in einer Mischkristallreihe liegt mit Zusammensetzung gemäß der allgemeinen Formel

$$\{Gd_{3-x}Ca_x\}[Ga_{2-x-y-2z}Gd_yMg_zHf_{x+z}](Ga_3)O_{12},$$

worin sind

$$0 \leq x \leq 0,15$$
$$0,01 \leq y \leq 0,02$$
$$0 \leq z \leq 0,20$$
$$0,15 \leq x + z \leq 0,20.$$

**11.** Verfahren nach Anspruch 10,
dadurch gekennzeichnet,
daß das Anfangsglied der Mischkristallreihe die Schmelzzusammensetzung hat

$$\{Gd_{2,85}Ca_{0,15}\}[Ga_{1,83}Gd_{0,02}Hf_{0,15}](Ga_3)O_{12}$$

EP 0 383 400 B1

und daß das Endglied der Mischkristallreihe die Schmelzzusammensetzung hat

$\{Gd_{3,00}\}[Ga_{1,59}Gd_{0,01}Mg_{0,20}Hf_{0,20}](Ga_3)O_{12}$.

**12.** Verfahren nach Anspruch 9,
dadurch gekennzeichnet,
daß die Zusammensetzung der Mischkristalle in einer Mischkristallreihe liegt mit Zusammensetzung gemäß der allgemeinen Formel

$\{Tb_{3-x}Ca_x\}[Ga_{2-x-y-2z}Tb_yMg_zHf_{x+z}](Ga_3)O_{12}$,

worin sind

$$0,05 \leqq x \leqq 0,35$$
$$0,02 \leqq y \leqq 0,03$$
$$0 \leqq z \leqq 0,55$$
$$0,35 \leqq x + z \leqq 0,60.$$

**13.** Verfahren nach Anspruch 12,
dadurch gekennzeichnet,
daß das Anfangsglied der Mischkristallreihe die Schmelzzusammensetzung hat

$\{Tb_{2,65}Ca_{0,35}\}[Ga_{1,62}Tb_{0,03}Hf_{0,35}](Ga_3)O_{12}$

und daß das Endglied der Mischkristallreihe die Schmelzzusammensetzung hat

$\{Tb_{2,95}Ca_{0,05}\}[Ga_{0,83}Tb_{0,02}Mg_{0,55}Hf_{0,60}] (Ga_3)O_{12}$.

**14.** Verfahren nach Anspruch 9,
dadurch gekennzeichnet,
daß die Zusammensetzung der Mischkristalle in einer Mischkristallreihe liegt mit Zusammensetzung gemäß der allgemeinen Formel

$\{Dy_{3-x}Ca_x\}[Ga_{2-x-y-2z}Dy_yMg_zHf_{x+z}](Ga_3)O_{12}$,

worin sind

$$0,25 \leqq x \leqq 0,38$$
$$0,05 \leqq y \leqq 0,11$$
$$0 \leqq z \leqq 0,35$$
$$0,38 \leqq x + z \leqq 0,60.$$

**15.** Verfahren nach Anspruch 14,
dadurch gekennzeichnet,
daß das Anfangsglied der Mischkristallreihe die Schmelzzusammensetzung hat

$\{Dy_{2,62}Ca_{0,38}\}[Ga_{1,51}Dy_{0,11}Hf_{0,38}](Ga_3)O_{12}$

und daß das Endglied der Mischkristallreihe die Schmelzzusammensetzung hat

$\{Dy_{2,75}Ca_{0,25}\}[Ga_{1,00}Dy_{0,05}Mg_{0,35}Hf_{0,60}] (Ga_3)O_{12}$.

**16.** Verfahren nach Anspruch 9,
dadurch gekennzeichnet,
daß die Zusammensetzung der Mischkristalle in einer Mischkristallreihe liegt mit Zusammensetzung gemäß der allgemeinen Formel

22

$\{Y_{3-x}Ca_x\}[Ga_{2-x-y-2z}Y_yMg_zHf_{x+z}](Ga_3)O_{12}$,

worin sind

$$0,39 \leq x \leq 0,49$$
$$0,18 \leq y \leq 0,19$$
$$0 \leq z \leq 0,20$$
$$0,49 \leq x + z \leq 0,60.$$

**17.** Verfahren nach Anspruch 16,
dadurch gekennzeichnet,
daß das Anfangsglied der Mischkristallreihe die Schmelzzusammensetzung hat

$\{Y_{2,51}Ca_{0,49}\}[Ga_{1,33}Y_{0,18}Hf_{0,49}](Ga_3)O_{12}$

und daß das Endglied der Mischkristallreihe die Schmelzzusammensetzung hat

$\{Y_{2,60}Ca_{0,40}\}[Ga_{1,01}Y_{0,19}Mg_{0,20}Hf_{0,60}]$
$(Ga_3)O_{12}$.

**18.** Verfahren nach Anspruch 9,
dadurch gekennzeichnet,
daß die Zusammensetzung der Mischkristalle in einer Mischkristallreihe liegt mit Zusammensetzung gemäß der allgemeinen Formel

$\{Er_{3-x}Ca_x\}[Ga_{2-x-y-2z}(Er,In)_yMg_zHf_{x+z}](Ga_3)O_{12}$,

worin sind

$$0,49 \leq x \leq 0,55$$
$$0,18 \leq y \leq 0,28; \text{ Er bis } 0,24$$
$$0 \leq z \leq 0,11$$
$$0,55 \leq x + z \leq 0,60.$$

**19.** Verfahren nach Anspruch 18,
dadurch gekennzeichnet,
daß das Anfangsglied der Mischkristallreihe die Schmelzzusammensetzung hat

$\{Er_{2,45}Ca_{0,55}\}[Ga_{1,17}Er_{0,18}In_{0,10}Hf_{0,55}]$
$(Ga_3)O_{12}$

und daß das Endglied der Mischkristallreihe die Schmelzzusammensetzung hat

$\{Er_{2,51}Ca_{0,49}\}$
$[Ga_{1,01}Er_{0,18}In_{0,10}Mg_{0,11}Hf_{0,60}](Ga_3)O_{12}$.

**20.** Verfahren nach mindestens einem der Ansprüche 1 bis 8,
dadurch gekennzeichnet,
daß Mischkristalle gezüchtet werden mit einer Zusammensetzung gemäß der allgemeinen Formel

$\{RE_{3-x}Ca_x\}[Ga_{2-x-y-2z}RE_yMg_zZr_{x+z}](Ga_3)O_{12}$,

worin sind
RE = ein Kation aus der Gruppe $Sm^{3+}$, $Eu^{3+}$, $Tb^{3+}$ und

$$0 \leq x \leq 0,58$$
$$0 \leq y \leq 0,10$$
$$0 \leq z \leq 0,50$$

EP 0 383 400 B1

$$0,15 \leq x + z \leq 0,68.$$

**21.** Verfahren nach Anspruch 20,
dadurch gekennzeichnet,
daß die Zusammensetzung der Mischkristalle in einer Mischkristallreihe liegt mit Zusammensetzung gemäß der allgemeinen Formel

$$\{Tb_{3-x}Ca_x\}[Ga_{2-x-y-2z}Tb_yMg_zZr_{x+z}](Ga_3)O_{12},$$

worin sind

$$0,50 \leq x \leq 0,58$$
$$0,07 \leq y \leq 0,10$$
$$0 \leq z \leq 0,08$$
$$0,58 \leq x + z \leq 0,60.$$

**22.** Verfahren nach Anspruch 21,
dadurch gekennzeichnet,
daß das Anfangsglied der Mischkristallreihe die Schmelzzusammensetzung hat

$$\{Tb_{2,42}Ca_{0,58}\}[Ga_{1,34}Tb_{0,08}Zr_{0,58}](Ga_3)O_{12}$$

und daß das Endglied der Mischkristallreihe die Schmelzzusammensetzung hat

$$\{Tb_{2,48}Ca_{0,52}\}[Ga_{1,22}Tb_{0,10}Mg_{0,08}Zr_{0,60}]$$
$$(Ga_3)O_{12}.$$

**23.** Verfahren nach Anspruch 20,
dadurch gekennzeichnet,
daß die Zusammensetzung der Mischkristalle in einer Mischkristallreihe liegt mit Zusammensetzung gemäß der allgemeinen Formel

$$\{Eu_{3-x}Ca_x\}[Ga_{2-x-y-2z}Eu_yMg_zZr_{x+z}](Ga_3)O_{12},$$

worin sind

$$0,06 \leq x \leq 0,32$$
$$0,01 \leq y \leq 0,02$$
$$0 \leq z \leq 0,50$$
$$0,32 \leq x + z \leq 0,56.$$

**24.** Verfahren nach Anspruch 23,
dadurch gekennzeichnet,
daß das Anfangsglied der Mischkristallreihe die Schmelzzusammensetzung hat

$$\{Eu_{2,68}Ca_{0,32}\}[Ga_{1,66}Eu_{0,02}Zr_{0,32}](Ga_3)O_{12}$$

und daß das Endglied der Mischkristallreihe die Schmelzzusammensetzung hat

$$\{Eu_{2,94}Ca_{0,06}\}[Ga_{0,95}Eu_{0,01}Mg_{0,49}Zr_{0,55}]$$
$$(Ga_3)O_{12}.$$

**25.** Verfahren nach Anspruch 20,
dadurch gekennzeichnet,
daß die Zusammensetzung der Mischkristalle in einer Mischkristallreihe liegt mit Zusammensetzung gemäß der allgemeinen Formel

$$\{Sm_{3-x}Ca_x\}[Ga_{2-x-y-2z}Sm_yMg_zZr_{x+z}](Ga_3)O_{12},$$

24

worin sind

$$0 \leq x \leq 0,15$$
$$0 \leq y \leq 0,01$$
$$0 \leq z \leq 0,20$$
$$0,15 \leq x + z \leq 0,20.$$

26. Verfahren nach Anspruch 25,
dadurch gekennzeichnet,
daß das Anfangsglied der Mischkristallreihe die Schmelzzusammensetzung hat

$$\{Sm_{2,85}Ca_{0,15}\}[Ga_{1,85}Zr_{0,15}](Ga_3)O_{12}$$

und daß das Endglied der Mischkristallreihe die Schmelzzusammensetzung hat

$$\{Sm_3\}[Ga_{1,60}Mg_{0,20}Zr_{0,20}](Ga_3)O_{12}.$$

27. Verfahren nach mindestens einem der Ansprüche 1 bis 8,
dadurch gekennzeichnet,
daß Mischkristalle gezüchtet werden mit einer Zusammensetzung gemäß der allgemeinen Formel

$$\{RE_{3-u-v}Ca_uMg_v\}[In_{2-w-x}Mg_wZr_x]$$
$$(Ga_{3-y-z}Ge_yMg_z)O_{12},$$

worin sind
    RE =     ein Kation aus der Gruppe $Pr^{3+}$, $Nd^{3+}$ und

$$0 \leq u \leq 0,60$$
$$0 \leq v \leq 0,06$$
$$1,25 \leq w \leq 1,50$$
$$0 \leq x \leq 0,50$$
$$1,32 \leq y \leq 1,60$$
$$0,03 \leq z \leq 0,15$$

28. Verfahren nach Anspruch 27,
dadurch gekennzeichnet,
daß die Zusammensetzung der Mischkristalle in einer Mischkristallreihe liegt mit Zusammensetzung gemäß der allgemeinen Formel

$$\{Pr_{3-u-v}Ca_uMg_v\}[In_{2-w-x}Mg_wZr_x]$$
$$(Ga_{3-y-z}Ge_yMg_z)O_{12},$$

worin sind

$$0 \leq u \leq 0,20$$
$$0,03 \leq v \leq 0,06$$
$$1,33 \leq w \leq 1,36$$
$$0 \leq x \leq 0,25$$
$$1,47 \leq y \leq 1,50$$
$$0,08 \leq z \leq 0,15.$$

29. Verfahren nach Anspruch 28,
dadurch gekennzeichnet,
daß das Anfangsglied der Mischkristallreihe die Schmelzzusammensetzung hat

$$\{Pr_{2,97}Mg_{0,03}\}[In_{0,67}Mg_{1,33}]$$
$$(Ga_{1,42}Ge_{1,47}Mg_{0,11})O_{12}$$

und daß das Endglied der Mischkristallreihe die Schmelzzusammensetzung hat

$\{Pr_{2,77}Ca_{0,20}Mg_{0,03}\}[In_{0,40}Mg_{1,35}Zr_{0,25}]$
$(Ga_{1,37}Ge_{1,48}Mg_{0,15})O_{12}$.

30. Verfahren nach Anspruch 27,
dadurch gekennzeichnet,
daß die Zusammensetzung der Mischkristalle in einer Mischkristallreihe liegt mit Zusammensetzung gemäß der allgemeinen Formel

$\{Nd_{3-u-v}Ca_uMg_v\}[In_{2-w-x}Mg_wZr_x]$
$(Ga_{3-y-z}Ge_yMg_z)O_{12}$

worin sind

$$0 \leq u \leq 0,60$$
$$0 \leq v \leq 0,08$$
$$1,26 \leq w \leq 1,50$$
$$0 \leq x \leq 0,50$$
$$1,33 \leq y \leq 1,60$$
$$0 \leq z \leq 0,10.$$

31. Verfahren nach Anspruch 30,
dadurch gekennzeichnet,
daß das Anfangsglied der Mischkristallreihe die Schmelzzusammensetzung hat

$\{Nd_{2,97}Mg_{0,03}\}[In_{0,74}Mg_{1,26}]$
$(Ga_{1,63}Ge_{1,33}Mg_{0,04})O_{12}$.

32. Verfahren nach den Ansprüchen 1,2,7 und 8,
dadurch gekennzeichnet,
daß Mischkristalle gezüchtet werden mit einer Zusammensetzung gemäß der allgemeinen Formel

$RE_{1-x}Sr_xGa_{1-y}Zr_yO_3$, worin sind

RE =    ein Kation aus der Gruppe $La^{3+}$, $Pr^{3+}$, $Nd^{3+}$ und

$$0,05 \leq x \leq 0,10$$
$$0,05 \leq y \leq 0,10.$$

33. Verfahren nach Anspruch 32,
dadurch gekennzeichnet,
daß ein Mischkristall gezüchtet wird mit einer Schmelzzusammensetzung gemäß der Formel

$La_{0,95}Sr_{0,05}Ga_{0,95}Zr_{0,05}O_3$.

34. Verfahren nach den Ansprüchen 9 bis 19,
dadurch gekennzeichnet,
daß für die Anfangsglieder der Mischkristallreihen die Bindungslänge des Dodekaederplatzes $\{A(1)\text{-}O\}$ berechnet wird mit

$$\{A(1)\text{-}O\} = 0,30362 - 1,4571 \cdot \{r_{RE}\} + 7,8443 \cdot \{r_{RE}\}^2 \text{ (in Nanometer)},$$

und die Bindungslänge des Oktaederplatzes [B-O] berechnet wird mit

$$[B\text{-}O] = 0,25836 - 0,5436 \cdot \{r_{RE}\} \text{ (in Nanometer)},$$

26

EP 0 383 400 B1

worin $\{r_{RE}\}$ der Radius des Seltenerdmetallions auf dem Dodekaederplatz ist.

**35.** Verfahren nach Anspruch 34,
dadurch gekennzeichnet,
daß die Zunahme der Bindungslängen jeweils des Dodekaederplatzes $\{A(1)-O\}$ und des Oktaederplatzes $[B-O]$ in der Mischkristallreihe berechnet wird mit

$$\Delta \{A(1)-O\} = 0{,}1024 \cdot [\Delta \bar{r}] + 19{,}8482 \cdot [\Delta \bar{r}]^2 \text{(in Nanometer) und}$$
$$\Delta [B-O] = 0{,}6802 \cdot [\Delta \bar{r}] \text{ (in Nanometer),}$$

worin $[\Delta \bar{r}]$ die Differenz des mittleren Radius aller Kationen auf dem Oktaederplatz zum mittleren Radius aller Kationen auf dem Oktaederplatz der Anfangsglieder ist und wobei die berechneten Bindungslängendifferenzen zu den mittleren Bindungslängen der entsprechenden Gitterplätze des Anfangsgliedes der Mischkristallreihe addiert werden.

**36.** Verfahren nach den Ansprüchen 20 bis 26,
dadurch gekennzeichnet,
daß für die Anfangsglieder der Mischkristallreihen die Bindungslänge des Dodekaederplatzes $\{A(1)-O\}$ berechnet wird mit

$$\{A(1)-O\} = 0{,}25119 - 0{,}4027 \cdot \{r_{RE}\} + 2{,}6730 \cdot \{r_{RE}\}^2 \text{ (in Nanometer)}$$

und die Bindungslänge des Oktaederplatzes $[B-O]$ berechnet wird mit

$$[B-O] = 0{,}26266 - 0{,}5645 \cdot \{r_{RE}\} \text{ (in Nanometer),}$$

worin $\{r_{RE}\}$ der Radius des Seltenerdmetallions auf dem Dodekaederplatz ist.

**37.** Verfahren nach Anspruch 36,
dadurch gekennzeichnet,
daß die Zunahme der Bindungslängen jeweils des Dodekaederplatzes $\{A(1)-O\}$ und des Oktaederplatzes $[B-O]$ in der Mischkristallreihe berechnet wird mit

$$\Delta \{A(1)-O\} = 0{,}2070 \cdot [\Delta \bar{r}] + 6{,}0593 \cdot [\Delta \bar{r}]^2 \text{ (in Nanometer) und}$$
$$\Delta [B-O] = 0{,}6961 \cdot [\Delta \bar{r}] \text{ (in Nanometer),}$$

worin $[\Delta \bar{r}]$ die Differenz des mittleren Radius aller Kationen auf dem Oktaederplatz zum mittleren Radius aller Kationen auf dem Oktaederplatz der Anfangsglieder ist und wobei die berechneten Bindungslängendifferenzen zu den mittleren Bindungslängen der entsprechenden Gitterplätze des Anfangsgliedes der Mischkristallreihe addiert werden.

**38.** Verwendung der nach dem Verfahren gemäß den Ansprüchen 1 bis 37 hergestellten Mischkristalle als Substrat für die Herstellung monokristalliner Schichten auf Substraten.

**39.** Verwendung der nach dem Verfahren gemäß den Ansprüchen 1 bis 37 hergestellten Mischkristalle als Substrat für die Herstellung von auf einem Substrat angebrachten Vielschichtstrukturen aus unterschiedlichen monokristallinen Schichten einer Dicke von jeweils > 100 x a, wobei a die Gitterkonstante des Materials der jeweiligen Schicht ist.

**40.** Verwendung der nach dem Verfahren gemäß den Ansprüchen 1 bis 37 hergestellten Mischkristalle als Substrat für die Herstellung von auf einem Substrat angebrachten Vielschichtstrukturen aus unterschiedlichen monokristallinen Schichten einer Dicke von jeweils < 100 x a, wobei a die Gitterkonstante des Materials der jeweiligen Schicht ist.

**Claims**

**1.** A method of growing mixed crystals having at least two lattice sites with each a different number of adjacent oxygen ions from melts of oxidic multi-component systems,

characterized in that,
homogeneous mixed crystals having a garnet, perovskite or spinel structure are grown in such a manner that the cations intended to occupy the first lattice site having the largest number of adjacent oxygen ions and to occupy the second lattice site having the second largest number of adjacent oxygen ions are selected such that the ratio of the average cation bond length calculated for the cations in the first lattice site to the average cation bond length calculated for the cations in the second lattice site is in the range from 0.7 to 1.5.

2. A method as claimed in Claim 1,
characterized in that,
the ratio of the average cation bond length calculated for the cations in the first lattice site to the average cation bond length calculated for the cations in the second lattice site is in the range from 1.16 to 1.24.

3. A method of growing mixed crystals on the basis of rare earth metal-gallium-garnet as claimed in the Claims 1 and 2,
characterized in that,
the composition of the components forming the melt for growing homogeneous mixed crystals is selected in dependence on the bond lengths of the dodecahedral site {A(1)-0} and of the octahedral site [B-0], such that the calculated average bond length of the dodecahedral site {A(1)-0} is in the range from 0.2361 nm to 0.2453 nm and the calculated average bond length of the octahedral site [B-0] is in the range from 0.2008 nm to 0.2108 nm.

4. A method as claims in Claim 3,
characterized in that,
the composition of the components forming the melt is chosen in dependence on the calculated average bond lengths of the dodecahedral site {A(1)-0} and of the octahedral site [B-0], such that the calculated average bond length of the dodecahedral site {A(1)-0} is in the range from 0.2361 nm to 0.2377 nm and the calculated average bond length of the octahedral site [B-0] is in the range from 0.2008 nm to 0.2044 nm.

5. A method as claimed in Claim 3,
characterized in that, the composition of the components forming the melt is chosen in dependence on the calculated average bond lengths of the dodecahedral site {A(1)-0} and of the octahedral site [B-0], such that the calculated average bond length of the dodecahedral site {A(1)-0} is in the range from 0.2383 nm to 0.2397 nm and the calculated average bond length of the octahedral site [B-0] in the range from 0.2013 nm to 0.2052 nm.

6. A method as claimed in Claim 3,
characterized in that,
the composition of the components forming the melt is chosen in dependence on the calculated average bond length of the dodecahedral site {A(1)-0} and of the octahedral site [B-0], such that the calculated average bond length of the dodecahedral site {A(1)-0} is in the range from 0.2443 nm to 0.2453 nm, and the calculated average bond length of the octahedral site [B-0] is in the range from 0.2103 nm to 0.2108 nm.

7. A method as claimed in Claims 1 to 6,
characterized in that,
to occupy the first lattice site there are introduced in the system cations from the group
$K^{1+}$, $Ba^{2+}$, $Pb^{2+}$, $Sr^{2+}$, $La^{3+}$, $Na^{1+}$, $Ce^{3+}$, $Pr^{3+}$, $Bi^{3+}$, $Ca^{2+}$, $Nd^{3+}$, $Cd^{2+}$, $Th^{4+}$, $Sm^{3+}$, $Eu^{3+}$, $Gd^{3+}$, $Tb^{3+}$, $Dy^{3+}$, $Ho^{3+}$, $Y^{3+}$, $Er^{3+}$, $Tm^{3+}$, $Yb^{3+}$, $Lu^{3+}$, $Ce^{4+}$, $Mn^{2+}$, $Cu^{2+}$, $In^{3+}$, $Li^{1+}$, $Fe^{2+}$, $Zn^{2+}$, $Co^{2+}$, $Mg^{2+}$, $Sc^{3+}$, $Sn^{4+}$, $Ti^{4+}$, $Ni^{2+}$

8. A method as claimed in Claims 1 to 6,
characterized in that,
to occupy the second lattice site there are introduced into the system cations from the group
$Sm^{3+}$, $Eu^{3+}$, $Gd^{3+}$, $Tb^{3+}$, $Dy^{3+}$, $Ho^{3+}$, $Y^{3+}$, $Eu^{3+}$, $Tm^{3+}$, $Yb^{3+}$, $Lu^{3+}$, $Mn^{2+}$, $In^{3+}$, $Fe^{2+}$, $Pb^{4+}$, $Li^{1+}$, $Sc^{3+}$, $Zr^{4+}$, $Co^{2+}$, $Zn^{2+}$, $Cu^{2+}$, $Mg^{2+}$, $Hf^{4+}$, $Sn^{4+}$, $Ni^{2+}$, $Rh^{3+}$, $Mn^{3+}$, $Fe^{3+}$, $V^{3+}$, $Ta^{5+}$, $Nb^{5+}$, $Pt^{4+}$, $Ru^{4+}$, $Cr^{3+}$,

$Ga^{3+}$, $Co^{3+}$, $Ti^{4+}$, $Ni^{3+}$, $Cu^{3+}$, $Al^{3+}$, $Mn^{4+}$, $Ge^{4+}$.

9. A method as claimed in at least one of the Claims 1 to 8, <u>characterized in that,</u> mixed crystals are grown having a composition defined by the general formula

$$\{RE_{3-x}Ca_x\}[Ga_{2-x-y-2z}R_yMg_zHf_{x+z}](Ga_3)O_{12}$$

wherein

RE = a cation from the group
$Gd^{3+}$, $Tb^{3+}$, $Dy^{3+}$, $Ho^{3+}$, $Y^{3+}$, $Er^{3+}$
R = In and/or RE and

$$0 \leq x \leq 0.55$$
$$0.01 \leq y \leq 0.28$$
$$0 \leq z \leq 0.55$$
$$0.15 \leq x + z \leq 0.60$$

10. A method as claimed in Claim 9,
<u>characterized in that,</u>
the composition of the mixed crystals is in accordance with a mixed crystal series having a compositions defined by the general formula

$$\{Gd_{3-x}Ca_x\}[Ga_{2-x-y-2z}Gd_yMg_zHf_{x+z}](Ga_3)O_{12}$$

wherein

$$0 \leq x \leq 0.15$$
$$0.01 \leq y \leq 0.02$$
$$0 \leq z \leq 0.20$$
$$0.15 \leq x + z \leq 0.20$$

11. A method as claimed in Claim 10,
<u>characterized in that,</u> the initial member of the mixed crystal series has the melt composition

$$\{Gd_{2,85}Ca_{0,15}\}[Ga_{1,83}Gd_{0,02}Hf_{0,15}](Ga_3)O_{12}$$

and that the terminal member of the mixed crystal series has the melt composition

$$\{Gd_{3,00}\}[Ga_{1,59}Gd_{0,01}Mg_{0,20}Hf_{0,20}](Ga_3)O_{12}$$

12. A method as claimed in Claim 9,
<u>characterized in that,</u>
the composition of the mixed crystals is in accordance with a mixed crystal series having a composition defined by the general formula

$$\{Tb_{3-x}Ca_x\}[Ga_{2-x-y-2z}Tb_yMg_zHf_{x+z}](Ga_3)O_{12}$$

wherein

$$0.05 \leq x \leq 0.35$$
$$0.02 \leq y \leq 0.03$$
$$0 \leq z \leq 0.55$$
$$0.35 \leq x + z \leq 0.60$$

13. A method as claimed in Claim 12,
<u>characterized in that,</u>
the initial member of the mixed crystal series has the melt composition

$\{Tb_{2,65}Ca_{0,35}\}[Ga_{1,62}Tb_{0,03}Hf_{0,35}](Ga_3)O_{12}$

and that the terminal member of the mixed crystal series has the melt composition

$\{Tb_{2,95}Ca_{0,05}\}[Ga_{0,83}Tb_{0,02}Mg_{0,55}Hf_{0,60}](Ga_3)O_{12}$

**14.** A method as claimed in Claim 9,
characterized in that,
the composition of the mixed crystals is in accordance with a mixed crystal series having a composition defined by the general formula

$\{Dy_{3-x}Ca_x\}[Ga_{2-x-y-2z}Dy_yMg_zHf_{x+z}](Ga_3)O_{12}$

wherein

$$0.25 \leq x \leq 0.38$$
$$0.05 \leq y \leq 0.11$$
$$0 \leq z \leq 0.35$$
$$0.38 \leq x + z \leq 0.60$$

**15.** A method as claimed in Claim 14,
characterized in that,
the initial member of the mixed crystal series has the melt composition

$\{Dy_{2,62}Ca_{0,38}\}[Ga_{1,51}Dy_{0,11}Hf_{0,38}](Ga_3)O_{12}$

and that the terminal member of the mixed crystal series has the melt composition

$\{Dy_{2,75}Ca_{0,25}\}[Ga_{1,00}Dy_{0,05}Mg_{0,35}Hf_{0,60}](Ga_3)O_{12}$

**16.** A method as claimed in Claim 9,
characterized in that,
the composition of the mixed crystals is in accordance with a mixed crystal series having a composition defined by the general formula

$\{Y_{3-x}Ca_x\}[Ga_{2-x-y-2z}Y_yMg_zHf_{x+z}](Ga_3)O_{12}$

wherein

$$0.39 \leq x \leq 0.49$$
$$0.18 \leq y \leq 0.19$$
$$0 \leq z \leq 0.20$$
$$0.49 \leq x + z \leq 0.60$$

**17.** A method as claimed in Claim 16,
characterized in that,
the initial member of the mixed crystal series has the melt composition

$\{Y_{2,51}Ca_{0,49}\}[Ga_{1,33}Y_{0,18}Hf_{0,49}](Ga_3)O_{12}$

and that the terminal member of the mixed crystal series has the melt composition

$\{Y_{2,60}Ca_{0,40}\}[Ga_{1,01}Y_{0,19}Mg_{0,20}Hf_{0,60}](Ga_3)O_{12}$

**18.** A method as claimed in Claim 9,
characterized in that,
the composition of the mixed crystals is in accordance with a mixed crystal series having a composition defined by the general formula

$\{Er_{3-x}Ca_x\}[Ga_{2-x-y-2z}(Er,In)_yMg_zHf_{x+z}](Ga_3)O_{12}$

wherein

$$0.49 \leq x \leq 0.55$$
$$0.18 \leq y \leq 0.28, \text{ Er to } 0.24$$
$$0 \leq z \leq 0.11$$
$$0.55 \leq x + z \leq 0.60$$

19. A method as claimed in Claim 18,
   <u>characterized in that,</u>
   the initial member of the mixed crystal series has the melt composition

$\{Er_{2,45}Ca_{0,55}\}[Ga_{1,17}Er_{0,18}In_{0,10}Hf_{0,55}](Ga_3)O_{12}$

and that the terminal member of the mixed crystal series has the melt composition

$\{Er_{2,51}Ca_{0,49}\}[Ga_{1,01}Er_{0,18}In_{0,10}Mg_{0,11}Hf_{0,60}](Ga_3)O_{12}$

20. A method as claimed in at least one of the Claims 1 to 8,
   <u>characterized in that,</u>
   mixed crystals are grown having a composition defined by the general formula

$\{RE_{3-x}Ca_x\}[Ga_{2-x-y-2z}Re_yMg_zZr_{x+z}](Ga_3)O_{12}$

wherein
   RE = a cation from the group
   $Sm^{3+}$, $Eu^{3+}$, $Tb^{3+}$ and

$$0 \leq x \leq 0.58$$
$$0 \leq y \leq 0.10$$
$$0 \leq z \leq 0.50$$
$$0.15 \leq x + z \leq 0.68$$

21. A method as claimed in Claim 20,
   <u>characterized in that,</u>
   the composition of the mixed crystals is in accordance with a mixed crystal series having a composition defined by the general formula

$\{Tb_{3-x}Ca_x\}[Ga_{2-x-y-2z}Tb_yMg_zZr_{x+z}](Ga_3)O_{12}$

wherein

$$0.50 \leq x \leq 0.58$$
$$0.07 \leq y \leq 0.10$$
$$0 \leq z \leq 0.08$$
$$0.58 \leq x + z \leq 0.60$$

22. A method as claimed in Claim 21,
   <u>characterized</u>
   in that the initial member of the mixed crystal series has the melt composition

$\{Tb_{2,42}Ca_{0,58}\}[Ga_{1,34}Tb_{0,08}Zr_{0,58}](Ga_3)O_{12}$

and in that the terminal member of the mixed crystal series has the melt composition

$\{Tb_{2,48}Ca_{0,52}\}[Ga_{1,22}Tb_{0,10}Mg_{0,08}Zr_{0,60}](Ga_3)O_{12}$

23. A method as claimed in Claim 20,
characterized
in that the composition of the mixed crystals is in accordance with a mixed crystal series having a composition defined by the general formula

$\{Eu_{3-x}Ca_x\}[Ga_{2-x-y-2z}Eu_yMg_zZr_{x+z}](Ga_3)O_{12}$

wherein

$$0.06 \leqq x \leqq 0.32$$
$$0.01 \leqq y \leqq 0.02$$
$$0 \leqq z \leqq 0.50$$
$$0.32 \leqq x + z \leqq 0.56$$

24. A method as claimed in Claim 23,
characterized
in that the initial member of the mixed crystal series has the melt composition

$\{Eu_{2,68}Ca_{0,32}\}[Ga_{1,66}Eu_{0,02}Zr_{0,32}](Ga_3)O_{12}$

and that the terminal member of the mixed crystal series has the melt composition

$\{Eu_{2,94}Ca_{0,06}\}[Ga_{0,95}Eu_{0,01}Mg_{0,49}Zr_{0,55}](Ga_3)O_{12}$

25. A method as claimed in Claim 20,
characterized
in that the composition of the mixed crystals is in accordance with a mixed crystal series having a composition defined by the general formula

$\{Sm_{3-x}Ca_x\}[Ga_{2-x-y-2z}Sm_yMg_zZr_{x+z}](Ga_3)O_{12}$

wherein

$$0 \leqq x \leqq 0.15$$
$$0 \leqq y \leqq 0.01$$
$$0 \leqq z \leqq 0.20$$
$$0.15 \leqq x + z \leqq 0.20$$

26. A method as claimed in Claim 25,
characterized
in that the initial member of the mixed crystal series has the melt composition

$[Sm_{2,85}Ca_{0,15}\}[Ga_{1,85}Zr_{0,15}](Ga_3)O_{12}$

and that the terminal member of the mixed crystal series has the melt composition

$\{Sm_3\}[Ga_{1,60}Mg_{0,20}Zr_{0,20}](Ga_3)O_{12}$

27. A method as claimed in at least one of the Claims 1 to 8,
characterized
in that the mixed crystals are grown such that they have a composition defined by the general formula

$\{RE_{3-u-v}Ca_uMg_v\}[In_{2-w-x}Mg_wZr_x](Ga_{3-y-z}Ge_yMg_z)O_{12}$

wherein
RE = a cation from the group $Pr^{3+}$, $Nd^{3+}$ and

$$0 \leqq u \leqq 0.60$$

EP 0 383 400 B1

$$0 \leq v \leq 0.06$$
$$1.25 \leq w \leq 1.50$$
$$0 \leq x \leq 0.50$$
$$1.32 \leq y \leq 1.60$$
$$0.03 \leq z \leq 0.15$$

**28.** A method as claimed in Claim 27,
characterized
in that the composition of the mixed crystals is in accordance with a mixed crystal series having a composition defined by the general formula

$$\{Pr_{3-u-v}Ca_uMg_v\}[In_{2-w-x}Mg_wZr_x](Ga_{3-y-z}Ge_yMg_z)O_{12}$$

wherein

$$0 \leq u \leq 0.20$$
$$0.03 \leq v \leq 0.06$$
$$1.33 \leq w \leq 1.36$$
$$0 \leq x \leq 0.25$$
$$1.47 \leq y \leq 1.50$$
$$0.08 \leq z \leq 0.15$$

**29.** A method as claimed in Claim 28,
characterized
in that the initial member of the mixed crystal series has the melt composition

$$\{Pr_{2,97}Mg_{0,03}\}[In_{0,67}Mg_{1,33}](Ga_{1,42}Ge_{1,47}Mg_{0,11})O_{12}$$

and that the terminal member of the mixed crystal series has the melt composition

$$\{Pr_{2,77}Ca_{0,20}Mg_{0,03}\}[In_{0,40}Mg_{1,35}Zr_{0,25}](Ga_{1,37}Ge_{1,48}Mg_{0,15})O_{12}$$

**30.** A method as claimed in Claim 27,
characterized
in that the composition of the mixed crystals is in accordance with a mixed crystal series having a composition defined by the general formula

$$\{Nd_{3-u-v}Ca_uMg_v\}[In_{2-w-x}Mg_wZr_x](Ga_{3-y-z}Ge_yMg_z)O_{12}$$

wherein

$$0 \leq u \leq 0.60$$
$$0 \leq v \leq 0.08$$
$$1.26 \leq w \leq 1.50$$
$$0 \leq x \leq 0.50$$
$$1.33 \leq y \leq 1.60$$
$$0 \leq z \leq 0.10$$

**31.** A method as claimed in Claim 30,
characterized
in that the initial member of the mixed crystal series has the melt composition

$$\{Nd_{2,97}Mg_{0,03}\}[In_{0,74}Mg_{1,26}](Ga_{1,63}Ge_{1,33}Mg_{0,04})O_{12}.$$

**32.** A method as claimed in Claims 1, 2, 7 and 8,
characterized
in that the mixed crystals are grown with a composition defined by the general formula

33

$RE_{1-x}Sr_xG_{1-y}Zr_yO_3$

wherein

RE = a cation from the group $La^{3+}$, $Pr^{3+}$, $Nd^3$ and

$$0.05 \leq x \leq 0.10$$
$$0.05 \leq y \leq 0.10$$

33. A method as claimed in Claim 32,
characterized
in that a mixed crystal is grown with a melt composition defined by the formula

$La_{0,95}Sr_{0,05}G_{0,95}Zr_{0,05}O_3$

34. A method as claimed in Claims 9 to 19,
characterized
in that for the initial members of the mixed crystal series the bond length of the dodecahedral site {A-(1)-0} is calculated with

$${A(1)-0} = 0.30362 - 1.4571 . \{r_{RE}\} + 7.8443 . \{r_{RE}\}^2 \text{ (in nanometre)}$$

and the bond length of the octahedral site [B-0] is calculated with

$$[B-0] = 0.25836 - 0.5436 . \{r_{RE}\} \text{ (in nanometre)}$$

wherein
$\{r_{RE}\}$ is the radius of the rare earth metal ion in the dodecahedral site.

35. A method as claimed in Claim 34,
characterized
in that the increase in the bond lengths of the dodecahedral site {A(1)-0} and of the octahedral site [B-0] in the mixed crystal series is calculated using

$$\Delta\{A(1)-0\} = 0.1024 . [\Delta r^-] + 19.8482 . [\Delta r^{-2}] \text{ (in nanometre) and}$$
$$\Delta[B-0] = 0.6802 . [\Delta r^-] \text{ (in nanometre)}$$

wherein
$[\Delta r^-]$ is the difference between the average radius of all the cations in the octahedral site and the average radius of all the cations in the octahedral site of the initial members, the calculated bond length differences being added to the average bond lengths of the corresponding lattice sites of the initial member of the mixed crystal series.

36. A method as claimed in Claims 20 to 26,
characterized
in that for the initial members of the mixed crystal series the bond length of the dodecahedral site {A-(1)-0} is calculated using

$${A(1)-0} = 0.25119 - 0.4027 . \{r_{RE}\} + 2.6730 . \{r_{RE}\}^2 \text{ (in nanometre)}$$

and the bond length of the octahedral site [B-0] is calculated using

$$\Delta[B-0] = 0.26266 - 0.5645 . \{r_{RE}\} \text{ (in nanometre)}$$

wherein
$\{r_{RE}\}$ is the radius of the rare earth metal ions in the dodecahedral site.

37. A method as claimed in Claim 36,
characterized

in that the increase in bond lengths of always the dodecahedral site {A(1)-0} and of the octahedral site [B-0] in the mixed crystal series is calculated using

$$\Delta\{A(1)-0\} = 0.2070 \cdot [\Delta r^-] + 6.0593 \cdot [\Delta r^-]^2 \text{ (in nanometre) and}$$
$$\Delta[B-0] = 0.6961 \cdot [\Delta r^-] \text{ (in nanometre)}$$

wherein

$[\Delta r^-]$ is the difference between the average radius of all the cations in the octahedral site and the average radius of all the cations in the octahedral site of the initial members, the calculated bond length differences being added to the average bond lengths of the corresponding lattice sites of the initial member of the mixed crystal series.

38. The use of the mixed crystals, produced in accordance with the method as claimed in Claims 1 to 37, as a substrate for the production of monocrystalline layers on substrates.

39. The use of the mixed crystals, produced in accordance with the method as claimed in the Claims 1 to 37, as a substrate for producing multilayer structures which are applied onto a substrate and which consist of different monocrystalline layers of a thickness of > 100 x a, wherein a is the lattice cosntant of the material of the specific layer.

40. The use of mixed crystals, produced in accordance with the method as claimed in Claims 1 to 37, as a substrate for producing multilayer structures which are applied onto a substrate and which consist of different monocrystalline layers of a thickness of < 100 x a, wherein a is the lattice constant of the material of each specific layer.

**Revendications**

1. Procédé de culture de cristaux mixtes avec au moins deux sites réticulaires avec, à chaque fois, un nombre différent d'ions oxygène voisins, à partir de masses fondues de systèmes polynaires oxydiques,
caractérisé en ce que l'on cultive des cristaux mixtes homogènes à structure de grenat, de perowskite, ou de spinelle, en une manière telle que l'on choisit les cations pour l'occupation du premier site du réseau ou site réticulaire avec le nombre le plus élevé d'ions oxygène voisins et pour l'occupation du second site du réseau ou site réticulaire avec le nombre inférieur suivant d'ions oxygène voisins, en sorte que le rapport de la longueur de liaison moyenne, calculée pour le premier site réticulaire, des cations sur le premier site réticulaire, à la longueur de liaison moyenne, calculée pour le second site réticulaire, des cations sur le second site réticulaire, fluctue dans la plage de 0,7 à 1,5.

2. Procédé suivant la revendication 1,
caractérisé en ce que le rapport de la longueur de liaison moyenne, calculée pour le premier site réticulaire, des cations sur le premier site réticulaire à la longueur de liaison moyenne, calculée pour le second site réticulaire, des cations sur le second site réticulaire, varie de 1,16 à 1,24.

3. Procédé de culture de cristaux mixtes à base de grenat à métal des terres rares-gallium suivant les revendications 1 et 2, caractérisé en ce que la composition des composants formant la masse fondue pour la culture de cristaux mixtes homogènes en fonction de, à chaque fois, les longueurs de liaison du site dodécaédrique {A(1)-O} et du site octaédrique [B-O] est choisie en une manière telle que la longueur de liaison, calculée pour le site dodécaédrique, du site dodécaédrique {A(1)-O} se situe dans la plage de 0,2361 nm à 0,2453 nm, et la longueur de liaison moyenne, calculée pour le site octaédrique, du site octaédrique [B-O] se situe dans la plage de 0,2008 nm à 0,2108 nm.

4. Procédé suivant la revendication 3, caractérisé en ce que la composition des composants formant la masse fondue en fonction de, à chaque fois, les longueurs de liaison moyennes, calculées, du site dodécaédrique {A(1)-O} et du site octaédrique [B-O], est choisie en une manière telle que la longueur de liaison moyenne, calculée pour le site dodécaédrique, du site dodécaédrique {A(1)-O} se situe dans la plage de 0,2361 nm à 0,2377 nm, et la longueur de liaison moyenne, calculée pour le site octaédrique, du site octaédrique [B-O] se situe dans la plage de 0,2008 nm à 0,2044 nm.

**5.** Procédé suivant la revendication 3, caractérisé en ce que la composition des composants formant la masse fondue en fonction de, à chaque fois, les longueurs de liaison moyennes, calculées, du site dodécaédrique {A(1)-O} et du site octaédrique [B-O], est choisie en une manière telle que la longueur de liaison moyenne, calculée pour le site dodécaédrique, du site dodécaédrique {A(1)-O} se situe dans la plage de 0,2383 nm à 0,2397 nm, et la longueur de liaison moyenne, calculée pour le site octaédrique, du site octaédrique [B-O] se situe dans la plage de 0,2013 nm à 0,2052 nm.

**6.** Procédé suivant la revendication 3, caractérisé en ce que la composition des composants formant la masse fondue en fonction de, à chaque fois, les longueurs de liaison moyennes, calculées, du site dodécaédrique {A(1)-O} et du site octaédrique [B-O] est choisie en une manière telle que la longueur de liaison moyenne, calculée pour le site dodécaédrique, du site dodécaédrique {A(1)-O} se situe dans la plage de 0,2443 nm à 0,2453 nm, et la longueur de liaison moyenne, calculée pour le site octaédrique, du site octaédrique [B-O] se situe dans plage de 0,2103 nm à 0,2108 nm.

**7.** Procédé suivant les revendications 1 à 6, caractérisé en ce que pour l'occupation du premier site réticulaire, on a inclu des cations appartenant au groupe :
$K^{1+}$, $Ba^{2+}$, $Pb^{2+}$, $Sr^{2+}$, $La^{3+}$, $Na^{1+}$, $Ce^{3+}$, $Pr^{3+}$, $Bi^{3+}$, $Ca^{2+}$, $Nd^{3+}$, $Cd^{2+}$, $Th^{4+}$, $Sm^{3+}$, $Eu^{3+}$, $Gd^{3+}$, $Tb^{3+}$, $Dy^{3+}$, $Ho^{3+}$, $Y^{3+}$, $Er^{3+}$, $Tm^{3+}$, $Yb^{3+}$, $Lu^{3+}$, $Ce^{4+}$, $Mn^{2+}$, $Cu^{2+}$, $In^{3+}$, $Li^{1+}$, $Fe^{2+}$, $Zn^{2+}$, $Co^{2+}$, $Mg^{2+}$, $Sc^{3+}$, $Sn^{4+}$, $Ti^{4+}$, $Ni^{2+}$,
dans le système.

**8.** Procédé suivant les revendications 1 à 6, caractérisé en ce que pour l'occupation du premier site réticulaire, on a inclu des cations appartenant au groupe :
$Sm^{3+}$, $Eu^{3+}$, $Gd^{3+}$, $Tb^{3+}$, $Dy^{3+}$, $Ho^{3+}$, $Y^{3+}$, $Er^{3+}$, $Tm^{3+}$, $Yb^{3+}$, $Lu^{3+}$, $Mn^{2+}$, $In^{3+}$, $Fe^{2+}$, $Pb^{4+}$, $Li^{1+}$, $Sc^{3+}$, $Zr^{4+}$, $Co^{2+}$, $Zn^{2+}$, $Cu^{2+}$, $Mg^{2+}$, $Hf^{4+}$, $Sn^{4+}$, $Ni^{2+}$, $Rh^{3+}$, $Mn^{3+}$, $Fe^{3+}$, $V^{3+}$, $Ta^{5+}$, $Nb^{5+}$, $Pt^{4+}$, $Ru^{4+}$, $Cr^{3+}$, $Ga^{3+}$, $Co^{3+}$, $Ti^{4+}$, $Ni^{3+}$, $Cu^{3+}$, $Al^{3+}$, $Mn^{4+}$, $Ge^{4+}$,
dans le système.

**9.** Procédé suivant au moins l'une quelconque des revendications 1 à 8, caractérisé en ce que l'on cultive des cristaux mixtes avec une composition répondant à la formule générale :

$$\{RE_{3-x}Ca_x\}[GA_{2-x-y-2z}R_yMg_zHf_{x+z}](Ga_3)O_{12}$$

dans laquelle
RE représente un cation appartenant au groupe : $Gd^{3+}$, $Tb^{3+}$, $Dy^{3+}$ $Ho^{3+}$, $Y^{3+}$, $ER^{3+}$,
R représente In et/ou RE et

$$0 \leq x \leq 0,55$$
$$0,01 \leq y \leq 0,28$$
$$0 \leq z \leq 0,55$$
$$0,15 \leq x + z \leq 0,60.$$

**10.** Procédé suivant la revendication 9, caractérisé en ce que la composition des cristaux mixtes dans une série de cristaux mixtes répond à la formule générale :

$$\{Gd_{3-x}Ca_x\}[Ga_{2-x-y-2z}Gd_yMg_zHf_{x+z}](Ga_3)O_{12}$$

dans laquelle

$$0 \leq x \leq 0,15$$
$$0,01 \leq y \leq 0,02$$
$$0 \leq z \leq 0,20$$
$$0,15 \leq x + z \leq 0,20.$$

**11.** Procédé suivant la revendication 10, caractérisé en ce que le maillon de départ de la série des cristaux mixtes possède la composition de masse fondue suivante :

$$\{Gd_{2,85}Ca_{0,15}\}[Ga_{1,83}Gd_{0,02}Hf_{0,15}](Ga_3)O_{12}$$

et en ce que le maillon final de la série des cristaux mixtes possède la composition de masse fondue suivante :

$\{Gd_{3,00}\}[Ga_{1,59}Gd_{0,01}Mg_{0,20}Hf_{0,20}](Ga_3)O_{12}$

**12.** Procédé suivant la revendication 9, caractérisé en ce que la composition des cristaux mixtes dans une série de cristaux mixtes répond à la formule générale :

$\{Tb_{3-x}Ca_x\}[Ga_{2-x-y-2z}Tb_yMg_zHf_{x+z}](Ga_3)O_{12}$

dans laquelle

$$0,05 \leq x \leq 0,35$$
$$0,02 \leq y \leq 0,03$$
$$0 \leq z \leq 0,55$$
$$0,35 \leq x + z \leq 0,60.$$

**13.** Procédé suivant la revendication 12, caractérisé en ce que le maillon de départ de la série des cristaux mixtes possède la composition de masse fondue suivante :

$\{Tb_{2,65}Ca_{0,35}\}[Ga_{1,62}Tb_{0,03}Hf_{0,35}](Ga_3)O_{12}$

et en ce que le maillon final de la série des cristaux mixtes possède la composition de masse fondue suivante :

$\{Tb_{2,95}Ca_{0,05}\}[Ga_{0,83}Tb_{0,02}Mg_{0,55}Hf_{0,60}](Ga_3)O_{12}$

**14.** Procédé suivant la revendication 9, caractérisé en ce que la composition des cristaux mixtes dans une série de cristaux mixtes répond à la formule générale :

$\{Dy_{3-x}Ca_x\}[Ga_{2-x-y-2z}Dy_yMg_zHf_{x+z}](Ga_3)O_{12}$

dans laquelle

$$0,25 \leq x \leq 0,38$$
$$0,05 \leq y \leq 0,11$$
$$0 \leq z \leq 0,35$$
$$0,38 \leq x + z \leq 0,60.$$

**15.** Procédé suivant la revendication 14, caractérisé en ce que le maillon de départ de la série des cristaux mixtes possède la composition de masse fondue suivante :

$\{Dy_{2,62}Ca_{0,38}\}[Ga_{1,51}Dy_{0,11}Hf_{0,38}](Ga_3)O_{12}$

et en ce que le maillon final de la série des cristaux mixtes possède la composition de masse fondue suivante :

$\{Dy_{2,75}Ca_{0,25}\}[Ga_{1,00}Dy_{0,05}Mg_{0,35}Hf_{0,60}](Ga_3)O_{12}$

**16.** Procédé suivant la revendication 9, caractérisé en ce que la composition des cristaux mixtes dans une série de cristaux mixtes répond à la formule générale :

$\{Y_{3-x}Ca_x\}[Ga_{2-x-y-2z}Y_yMg_zHf_{x+z}](Ga_3)O_{12}$

dans laquelle

$$0,39 \leq x \leq 0,49$$

$$0,08 \leq y \leq 0,19$$
$$0 \leq z \leq 0,20$$
$$0,49 \leq x + z \leq 0,60.$$

**17.** Procédé suivant la revendication 16, caractérisé en ce que le maillon de départ de la série des cristaux mixtes possède la composition de masse fondue suivante :

$$\{Y_{2,51}Ca_{0,49}\}[Ga_{1,33}Y_{0,18}Hf_{0,49}](Ga_3)O_{12}$$

et en ce que le maillon final de la série des cristaux mixtes possède la composition de masse fondue suivante :

$$\{Y_{2,60}Ca_{0,40}\}[Ga_{1,01}Y_{0,19}Mg_{0,20}Hf_{0,60}](Ga_3)O_{12}$$

**18.** Procédé suivant la revendication 9, caractérisé en ce que la composition des cristaux mixtes dans une série de cristaux mixtes répond à la formule générale :

$$\{Er_{3-x}Ca_x\}[Ga_{2-x-y-2z}(Er,In)_yMg_zHf_{x+z}](Ga_3)O_{12}$$

dans laquelle

$$0,49 \leq x \leq 0,55$$
$$0,18 \leq y \leq 0,28; \text{ Er à } 0,24$$
$$0 \leq z \leq 0,11$$
$$0,55 \leq x + z \leq 0,60.$$

**19.** Procédé suivant la revendication 18, caractérisé en ce que le maillon de départ de la série des cristaux mixtes possède la composition de masse fondue suivante :

$$\{Er_{2,45}Ca_{0,55}\}[Ga_{1,17}Er_{0,18}In_{0,10}Hf_{0,55}](Ga_3)O_{12}$$

et en ce que le maillon final de la série des cristaux mixtes possède la composition de masse fondue suivante :

$$\{Er_{2,51}Ca_{0,49}\}[Ga_{1,01}Er_{0,18}In_{0,10}Mg_{0,11}Hf_{0,60}](Ga_3)O_{12}$$

**20.** Procédé suivant au moins l'une quelconque des revendications 1 à 8, caractérisé en ce qu'on cultive des cristaux mixtes d'une composition qui répond à la formule générale :

$$\{RE_{3-x}Ca_x\}[Ga_{2-x-y-2z}RE_yMg_zZr_{x+z}](Ga_3)O_{12}$$

dans laquelle
RE représente un cation appartenant au groupe $Sm^{3+}$, $Eu^{3+}$, $Tb^{3+}$ et

$$0 \leq x \leq 0,58$$
$$0 \leq y \leq 0,10$$
$$0 \leq z \leq 0,50$$
$$0,15 \leq x + z \leq 0,68.$$

**21.** Procédé suivant la revendication 20, caractérisé en ce que la composition des cristaux mixtes dans une série de cristaux mixtes répond à la formule générale :

$$\{Tb_{3-x}Ca_x\}[Ga_{2-x-y-2z}Tb_yMg_zZr_{x+z}](Ga_3)O_{12}$$

dans laquelle

$$0,50 \leq x \leq 0,58$$
$$0,07 \leq y \leq 0,10$$

$$0 \leq z \leq 0{,}08$$
$$0{,}58 \leq x + z \leq 0{,}60.$$

**22.** Procédé suivant la revendication 21, caractérisé en ce que le maillon de départ de la série des cristaux mixtes possède la composition de masse fondue suivante :

$$\{Tb_{2,42}Ca_{0,58}\}[Ga_{1,34}Tb_{0,08}Zr_{0,58}](Ga_3)O_{12}$$

et en ce que le maillon final de la série des cristaux mixtes possède la composition de masse fondue suivante :

$$\{Tb_{2,48}Ca_{0,52}\}[Ga_{1,22}Tb_{0,10}Mg_{0,08}Zr_{0,60}](Ga_3)O_{12}$$

**23.** Procédé suivant la revendication 20, caractérisé en ce que la composition des cristaux mixtes dans une série de cristaux mixtes répond à la formule générale :

$$\{Eu_{3-x}Ca_x\}[Ga_{2-x-y-2z}Eu_yMg_zZr_{x+z}](Ga_3)O_{12}$$

dans laquelle

$$0{,}06 \leq x \leq 0{,}32$$
$$0{,}01 \leq y \leq 0{,}02$$
$$0 \leq z \leq 0{,}50$$
$$0{,}32 \leq x + z \leq 0{,}56.$$

**24.** Procédé suivant la revendication 23, caractérisé en ce que le maillon de départ de la série des cristaux mixtes possède la composition de masse fondue suivante :

$$\{Eu_{2,68}Ca_{0,32}\}[Ga_{1,66}Eu_{0,02}Zr_{0,32}](Ga_3)O_{12}$$

et en ce que le maillon final de la série des cristaux mixtes possède la composition de masse fondue suivante :

$$\{Eu_{2,94}Ca_{0,06}\}[Ga_{0,95}Eu_{0,01}Mg_{0,49}Zr_{0,55}](Ga_3)O_{12}$$

**25.** Procédé suivant la revendication 20, caractérisé en ce que la composition des cristaux mixtes dans une série de cristaux mixtes répond à la formule générale :

$$\{Sm_{3-x}Ca_x\}[Ga_{2-x-y-2z}Sm_yMg_zZr_{x+z}](Ga_3)O_{12}$$

dans laquelle

$$0 \leq x \leq 0{,}15$$
$$0 \leq y \leq 0{,}01$$
$$0 \leq z \leq 0{,}20$$
$$0{,}15 \leq x + z \leq 0{,}20.$$

**26.** Procédé suivant la revendication 25, caractérisé en ce que le maillon de départ de la série des cristaux mixtes possède la composition de masse fondue suivante :

$$\{Sm_{2,85}Ca_{0,15}\}[Ga_{1,85}Zr_{0,15}](Ga_3)O_{12}$$

et en ce que le maillon final de la série des cristaux mixtes possède la composition de masse fondue suivante :

$$\{Sm_3\}[Ga_{1,60}Mg_{0,20}Zr_{0,20}](Ga_3)O_{12}$$

**27.** Procédé suivant au moins l'une quelconque des revendications 1 à 8, caractérisé en ce que l'on cultive des cristaux mixtes d'une composition qui répond à la formule générale :

$$\{RE_{3-u-v}Ca_uMg_v\}[In_{2-w-x}Mg_wZr_x](Ga_{3-y-z}Ge_yMg_z)O_{12}$$

dans laquelle
RE représente un cation appartenant au groupe $Pr^{3+}$, $Nd^{3+}$ et

$$0 \leq u \leq 0,60$$
$$0 \leq v \leq 0,06$$
$$1,25 \leq w \leq 1,50$$
$$0 \leq x \leq 0,50$$
$$1,32 \leq y \leq 1,60$$
$$0,03 \leq z \leq 0,15.$$

**28.** Procédé suivant la revendication 27, caractérisé en ce que la composition des cristaux mixtes dans une série de cristaux mixtes répond à la formule générale :

$$\{Pr_{3-u-v}Ca_uMg_v\}[In_{2-w-x}Mg_wZr_x](Ga_{3-y-z}Ge_yMg_z)O_{12}$$

dans laquelle

$$0 \leq u \leq 0,20$$
$$0,03 \leq v \leq 0,06$$
$$1,33 \leq w \leq 1,36$$
$$0 \leq x \leq 0,25$$
$$1,47 \leq y \leq 1,50$$
$$0,08 \leq z \leq 0,15.$$

**29.** Procédé suivant la revendication 28, caractérisé en ce que le maillon de départ de la série des cristaux mixtes possède la composition de masse fondue suivante :

$$\{Pr_{2,97}Mg_{0,03}\}In_{0,67}Mg_{1,33}](Ga_{1,42}Ge_{1,47}Mg_{0,11})O_{12}$$

et en ce que le maillon final de la série des cristaux mixtes possède la composition de masse fondue suivante :

$$\{Pr_{2,77}Ca_{0,20}Mg_{0,03}\}[In_{0,40}Mg_{1,35}Zr_{0,25}](Ga_{1,37}Ge_{1,48}Mg_{0,15})O_{12}$$

**30.** Procédé suivant la revendication 27, caractérisé en ce que la composition des cristaux mixtes dans une série de cristaux mixtes répond à la formule générale :

$$\{Nd_{3-u-v}Ca_uMg_v\}[In_{2-w-x}Mg_wZr_x](Ga_{3-y-z}Ge_yMg_z)O_{12}$$

dans laquelle

$$0 \leq u \leq 0,60$$
$$0 \leq v \leq 0,08$$
$$1,26 \leq w \leq 1,50$$
$$0 \leq x \leq 0,50$$
$$1,33 \leq y \leq 1,60$$
$$0 \leq z \leq 0,10.$$

**31.** Procédé suivant la revendication 30, caractérisé en ce que le maillon de départ de la série des cristaux mixtes possède la composition de masse fondue suivante :

$$\{Nd_{2,97}Mg_{0,03}\}[In_{0,74}Mg_{1,26}](Ga_{1,63}Ge_{1,33}Mg_{0,04})O_{12}$$

**32.** Procédé suivant les revendications 1, 2, 7 et 8, caractérisé en ce que l'on cultive des microcristaux avec une composition correspondant à la formule générale :

$$RE_{1-x}Sr_xGa_{1-y}Zr_yO_3$$

dans laquelle
RE représente un cation appartenant au groupe $La^{3+}$, $Pr^{3+}$, $Nd^{3+}$ et

$$0,05 \leq x \leq 0,10$$
$$0,05 \leq y \leq 0,10.$$

**33.** Procédé suivant la revendication 32, caractérisé en ce que l'on cultive un cristal mixte d'une composition de masse fondue correspondant à la formule :

$$La_{0,95}Sr_{0,05}Ga_{0,95}Zr_{0,05}O_3$$

**34.** Procédé suivant les revendications 9 à 19, caractérisé en ce que pour les maillons de départ des séries de cristaux mixtes, la longueur de liaison du site dodécaédrique {A(1)-O} est calculée avec

$$\{A(1)\text{-}O\} = 0,30362 - 1,4571 . \{r_{RE}\} + 7,8443 . \{r_{RE}\}^2 \text{ (en nanomètres)}$$

et la longueur de liaison du site octaédrique [B-O] est calculée avec

$$[B\text{-}O] = 0,25836 - 0,5436 . \{r_{RE}\} \text{ (en nanomètres)},$$

ou $\{r_{RE}\}$ représente le rayon de l'ion de métal des terres rares sur le site dodécaédrique.

**35.** Procédé suivant la revendication 34, caractérisé en ce que l'élévation des longueurs de liaison, à chaque fois du site dodécaédrique {A(1)-O} et du site octaédrique [B-O] dans la série de cristaux mixtes, est calculée avec

$$\Delta\{A(1)\text{-}O\} = 0,1024 . [\Delta\bar{r}] + 19,8482 . [\Delta\bar{r}]^2 \text{ (en nanomètres), et}$$
$$\Delta[B\text{-}O] = 0,6802 . [\Delta\bar{r}] \text{ (en nanomètres)}$$

où $[\Delta\bar{r}]$ représente la différence du rayon moyen de tous les cations sur le site octaédrique par rapport au rayon moyen de tous les cations sur le site octaédrique des maillons de départ et où les différences des longueurs de liaison calculées par rapport aux longueurs de liaison moyennes des sites réticulaires correspondants du maillon de départ des séries de cristaux mixtes sont additionnées.

**36.** Procédé suivant les revendications 20 à 26, caractérisé en ce que pour les maillons de départ des séries de cristaux mixtes, la longueur de liaison du site dodécaédrique {A(1)-O} est calculée avec

$$\{A(1)\text{-}O\} = 0,25119 - 0,4027 . \{r_{RE}\} + 2,6730 . \{r_{RE}\}^2 \text{ (en nanomètres)}$$

et la longueur de liaison du site octaédrique [B-O] est calculée avec

$$[B\text{-}O] = 0,26266 - 0,5645 . \{r_{RE}\} \text{ (en nanomètres)},$$

où $\{r_{RE}\}$ représente le rayon de l'ion de métal des terres rares sur le site dodécaédrique.

**37.** Procédé suivant la revendication 36, caractérisé en ce que l'élévation des longueurs de liaison, à chaque fois du site dodécaédrique {A(1)-O} et du site octaédrique [B-O] dans la série de cristaux mixtes, est calculée avec

$$\Delta\{A(1)\text{-}O\} = 0,2070 . [\Delta\bar{r}] + 6,0593 . [\Delta\bar{r}]^2 \text{ (en nanomètres), et}$$
$$\Delta[B\text{-}O] = 0,6961 . [\Delta\bar{r}] \text{ (en nanomètres)}$$

où $[\Delta\bar{r}]$ représente la différence du rayon moyen de tous les cations sur le site octaédrique par rapport

41

au rayon moyen de tous les cations sur le site octaédrique des maillons de départ et où les différences des longueurs de liaison calculées par rapport aux longueurs de liaison moyennes des sites réticulaires correspondants du maillon de départ des séries de cristaux mixtes sont additionnées.

38. Utilisation des cristaux mixtes fabriqués par mise en oeuvre du procédé suivant l'une quelconque des revendications 1 à 37, à titre de support pour la fabrication de couches monocristallines sur des supports.

39. Utilisation des cristaux mixtes fabriqués par mise en oeuvre du procédé suivant l'une quelconque des revendications 1 à 37, à titre de support pour la fabrication de structures polynaires déposées sur un support à partir de couches monocristallines différentes d'une épaisseur d'à chaque fois > 100 x a, où a est la constante réticulaire de la matière de la couche concernée.

40. Utilisation des cristaux mixtes fabriqués par mise en oeuvre du procédé suivant l'une quelconque des revendications 1 à 37, à titre de support pour la fabrication de structures polynaires déposées sur un support à partir de couches monocristallines différentes d'une épaisseur d'à chaque fois < 100 x a, où a est la constante réticulaire de la matière de la couche concernée.

Fig. 1

Fig. 2

Fig. 3

EP 0 383 400 B1

Fig. 4

Fig. 5

EP 0 383 400 B1

Fig. 6

Fig. 7